# EUROPEAN PATENT APPLICATION

(11) **EP 4 831 340 A1**
(43) Date of publication of application: **28.10.2026**
(21) Application number: 25830459.1
(22) Date of filing: 05.06.2025
(51) Int. Cl.: C23C 14/06, B32B 15/01, H10N 30/06, H10N 30/076, H10N 30/079

(54) **LAMINATED STRUCTURE AND ELECTRONIC DEVICE**

(30) Priority: 17.06.2024 JP 2024097261; 30.04.2025 JP 2025075811
(71) Applicant: Gaianixx Inc., Tokyo, 113-0033 (JP)
(72) Inventor: KIJIMA Takeshi, Tokyo 113-0033 (JP); SEKI Masashi, Tokyo 113-0033 (JP)
(74) Representative: Gille Hrabal Partnerschaftsgesellschaft mbB Patentanwälte
(86) International application number: PCT/JP2025/020369
(87) International publication number: WO 2025/263336

(57) **Abstract**

A laminated structure (10) includes a substrate (11) including a principal surface (11p), a buffer film (12) formed on the principal surface (11p), and a metal film (14) formed on the buffer film (12). The substrate (11) includes a Si substrate or an SOI substrate including a base body formed of a Si substrate, an insulating layer on the base body, and an SOI layer on the insulating layer. The buffer film (12) is made of a first metal oxide represented by the following composition formula (Chemical Formula 1), and x satisfies 0 ≤ x < 1 or x = 1. The metal film (14) contains Fe, Cu, Mo, W, Ag, Al, Ti, or Ir as a main component.

(Hf₁₋ₓZrₓ)O₂... (Chemical Formula 1)

## Description

### Technical Field

The present invention relates to a laminated structure and an electronic device.

### Background Art

A laminated structure including a substrate and a metal film formed on the substrate, and an electronic device including the laminated structure are known. As the electronic device, for example, a magnetic recording medium including a magnetic recording film formed of a metal film, a semiconductor integrated circuit including a wiring layer formed of a metal film, and the like are known.

JP H03-257905 A (Patent Literature 1) discloses a technique in which a stainless steel thin film for a magnetic recording film contains Ni in an amount of 15 wt% or more and 24 wt% or less and Cr in an amount of 16.5 wt% or more and 19 wt% or less, and has a fine structure in which fine crystallites composed of a ferromagnetic phase and fine crystallites composed of a nonmagnetic phase are mixed by being grown on a base material by a vapor quenching method. Further, JP 2024-061965 A (Patent Literature 2) discloses a technique of a laminated structure including at least a piezoelectric film and a metal film containing a metal as a main component, in which the metal is a metal that undergoes martensitic transformation by heat treatment or processing, and the metal contains Fe and Cr.

JP H07-054162 A (Patent Literature 3) discloses a technique in which a method for forming a metal thin film includes a step of laminating a Cu thin film on a base, a step of annealing the Cu thin film, and a step of epitaxially growing a metal thin film on the Cu thin film.

### Citation List

### Patent Literature

Patent Literature 1: JP H03-257905 A
Patent Literature 2: JP 2024-061965 A
Patent Literature 3: JP H07-054162 A

### Non Patent Literature

Non Patent Literature 1: L. S. Fan et al., "Stabilizing Ir(001) epitaxy on yttria-stabilized zirconia using a thin Ir seed layer grown by pulsed laser deposition", Crystal Growth and Design 17 (2017) 89-94

### Summary of Invention

### Technical Problem

In the technique described in Patent Literature 1, since a single-crystal-like stainless steel thin film cannot be formed on a substrate, it is difficult to improve the homogeneity of the physical properties such as magnetization characteristics of the entire stainless steel thin film and to improve the smoothness of a film surface. Also in the technique described in Patent Literature 2, it is desirable to further improve the electrical conductivity of the entire film and to further improve the smoothness of a film surface in the metal film.

In the technique described in Patent Literature 3, when the Cu thin film laminated on the base is annealed, the Cu thin film is strongly oriented in a (111) plane because Cu has a face-centered cubic structure. As a result, since a single-crystal-like Cu thin film cannot be formed on the base, it is difficult to improve the electrical conductivity of the entire Cu thin film and to improve the smoothness of a film surface.

An object of the present invention is to provide a laminated structure including a metal film formed on a substrate, and an electronic device including the laminated structure, in which a single-crystal-like metal film is formed on the substrate, the physical properties such as magnetization characteristics or electrical conductivity of the metal film are improved, and the smoothness of a film surface is improved.

### Solution to Problem

As a result of intensive studies, the present inventors have found that the above problems can be solved by the following configurations.
[1] A laminated structure including:
   a substrate including a principal surface;
   a first buffer film formed on the principal surface; and
   a first metal film formed on the first buffer film, wherein
   the substrate is a Si substrate or an SOI substrate including a base body formed of a Si substrate, an insulating layer on the base body, and an SOI layer on the insulating layer,
   the first buffer film is made of a first metal oxide represented by the following composition formula (Chemical Formula 1):

      (Hf₁₋ₓZrₓ)O₂... (Chemical Formula 1)
   the x satisfies 0 ≤ x < 1 or x = 1, and
   the first metal film contains Fe, Cu, Mo, W, Ag, Al, Ti, or Ir as a main component.
[2] The laminated structure according to [1], including
   a second metal film formed on the first buffer film, wherein
   the first metal film is formed on the second metal film, and
   the second metal film is made of Pt.
[3] The laminated structure according to [2], wherein
   the first buffer film is made of the first metal oxide epitaxially grown on the principal surface,
   the second metal film is made of Pt epitaxially grown on the first buffer film, and
   the first metal film is epitaxially grown on the second metal film.
[4] The laminated structure according to [2] or [3], wherein
   the substrate is a Si (100) substrate including the principal surface formed of a Si (100) plane, or the SOI substrate including the base body formed of a Si substrate, the insulating layer on the base body, and the SOI layer on the insulating layer, the SOI layer being formed of a Si (100) film and including the principal surface formed of a Si (100) plane,
   the first buffer film is made of the first metal oxide that is (100) oriented in a pseudo-cubic representation, and
   the second metal film has a cubic crystal structure and is (100) oriented.
[5] The laminated structure according to [4], wherein the first metal film contains Fe, has a cubic crystal structure, and is (100) oriented.
[6] The laminated structure according to [5], wherein the first metal film contains Cr or Ni.
[7] The laminated structure according to [4], wherein the first metal film contains Cu, has a cubic crystal structure, and is (100) oriented.
[8] The laminated structure according to [4], wherein the first metal film contains Mo, has a cubic crystal structure, and is (110) oriented.
[9] The laminated structure according to [4], wherein the first metal film contains W, has a cubic crystal structure, and is (110) oriented.
[10] The laminated structure according to [4], wherein the first metal film contains Ag, has a cubic crystal structure, and is (100) oriented.
[11] The laminated structure according to [4], wherein the first metal film contains Al, has a cubic crystal structure, and is (100) oriented.
[12] The laminated structure according to [4], wherein the first metal film contains Ti, has a cubic crystal structure, and is (110) oriented.
[13] The laminated structure according to [4], wherein the first metal film contains Ir, has a cubic crystal structure, and is (100) oriented.
[14] The laminated structure according to [2] or [3], wherein the substrate is a Si (111) substrate including the principal surface formed of a Si (111) plane, or the SOI substrate including the base body formed of a Si substrate, the insulating layer on the base body, and the SOI layer on the insulating layer, the SOI layer being formed of a Si (111) film and including the principal surface formed of a Si (111) plane,
   the first buffer film is made of the first metal oxide that is (111) oriented in a pseudo-cubic representation, and
   the second metal film has a cubic crystal structure and is (111) oriented.
[15] The laminated structure according to [14], wherein the first metal film contains Ir, has a cubic crystal structure, and is (111) oriented.
[16] The laminated structure according to [13] or [15], wherein the first buffer film includes:
   a second buffer film formed on the principal surface;
   a third buffer film formed on the second buffer film; and
   a fourth buffer film formed on the third buffer film,
   the second buffer film is made of a second metal oxide represented by the following composition formula (Chemical Formula 2):

      (Hf_{1-x1-y1}Zrₓ₁M_{y1})O_{2-z1}... (Chemical Formula 2)
   (provided that in the composition formula (Chemical Formula 2), M is one or more selected from the group consisting of Nb, Ta, Si, Ti, a rare earth element, Al, and a Group 2 element),
   the y1 satisfies 0 < y1 ≤ 0.3,
   the x1 satisfies 0 ≤ x1 ≤ 1 - y1,
   the third buffer film is made of a third metal oxide represented by the following composition formula (Chemical Formula 3):

      (REₓ₂Al_{y2})O_{z2}... (Chemical Formula 3)
   (provided that in the composition formula (Chemical Formula 3), RE is one or more selected from the group consisting of rare earth elements), and
   the fourth buffer film is made of a fourth metal oxide containing Ce.
[17] An electronic device including the laminated structure according to any one of [1] to [15].

### Advantageous Effects of Invention

The laminated structure and the electronic device including the laminated structure according to the present invention can form a single-crystal-like metal film on the substrate, improve the physical properties such as magnetization characteristics or electrical conductivity of the metal film, and improve the smoothness of a film surface.

### Brief Description of Drawings

Fig. 1 is a cross-sectional view illustrating an example of a laminated structure according to a first embodiment.
Fig. 2 is a cross-sectional view illustrating another example of the laminated structure according to the first embodiment.
Fig. 3 is a cross-sectional view illustrating another example of the laminated structure according to the first embodiment.
Fig. 4 is a cross-sectional view illustrating another example of the laminated structure according to the first embodiment.
Fig. 5 is a cross-sectional view illustrating another example of the laminated structure according to the first embodiment.
Fig. 6 is a cross-sectional view illustrating another example of the laminated structure according to the first embodiment.
Fig. 7 is a cross-sectional view illustrating an example of a laminated structure according to a modification of the first embodiment.
Fig. 8 is a cross-sectional view illustrating another example of the laminated structure according to the modification of the first embodiment.
Fig. 9 is a cross-sectional view of an electronic device according to a second embodiment.
Fig. 10 is a graph illustrating a diffraction pattern of a laminated structure of Example 1.
Fig. 11 is a graph illustrating a φ scan of the laminated structure of Example 1.
Fig. 12 is a graph illustrating a diffraction pattern of the laminated structure of Example 1.
Fig. 13 is a graph illustrating a φ scan of the laminated structure of Example 1.
Fig. 14 is a graph illustrating a φ scan of the laminated structure of Example 1.
Fig. 15 is a graph illustrating a diffraction pattern of a laminated structure of Example 2.
Fig. 16 is a graph illustrating a φ scan of the laminated structure of Example 2.
Fig. 17 is a graph illustrating a diffraction pattern of a laminated structure of Example 3.
Fig. 18 is a graph illustrating a φ scan of the laminated structure of Example 3.
Fig. 19 is a graph illustrating a diffraction pattern of a laminated structure of Example 4.
Fig. 20 is a graph illustrating a φ scan of the laminated structure of Example 4.
Fig. 21 is a graph illustrating a diffraction pattern of a laminated structure of Example 5.
Fig. 22 is a graph illustrating a φ scan of the laminated structure of Example 5.
Fig. 23 is a graph illustrating a diffraction pattern of a laminated structure of Example 6.
Fig. 24 is a graph illustrating a diffraction pattern of the laminated structure of Example 6.
Fig. 25 is a graph illustrating a φ scan of the laminated structure of Example 6.
Fig. 26 is a graph illustrating a diffraction pattern of a laminated structure of Example 7.
Fig. 27 is a graph illustrating a diffraction pattern of the laminated structure of Example 7.
Fig. 28 is a graph illustrating a φ scan of the laminated structure of Example 7.
Fig. 29 is a graph illustrating a diffraction pattern of a laminated structure of Example 8.
Fig. 30 is a graph illustrating a diffraction pattern of the laminated structure of Example 8.
Fig. 31 is a graph illustrating a φ scan of the laminated structure of Example 8.
Fig. 32 is a graph illustrating a diffraction pattern of a laminated structure of Example 9.
Fig. 33 is a graph illustrating a φ scan of the laminated structure of Example 9.

### Description of Embodiments

Hereinafter, embodiments of the present invention will be described with reference to the drawings.

### (First Embodiment)

### <Laminated Structure>

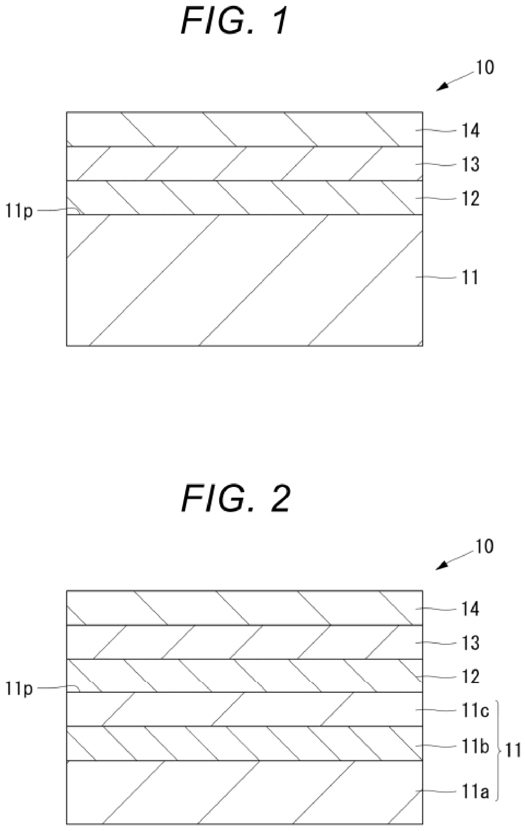

First, a laminated structure according to a first embodiment will be described. Fig. 1 is a cross-sectional view illustrating an example of the laminated structure according to the first embodiment. Figs. 2 to 4 are cross-sectional views illustrating other examples of the laminated structure according to the first embodiment.

A laminated structure 10 illustrated in Figs. 1 and 2 includes a substrate 11 including a principal surface 11p, a buffer film (first buffer film) 12 formed on the principal surface 11p, a metal film (second metal film) 13 formed on the buffer film 12, and a metal film (first metal film) 14 formed on the metal film (second metal film) 13.

In the example illustrated in Fig. 1, the substrate 11 includes a silicon (Si) (100) substrate including the principal surface 11p formed of a Si (100) plane. In the example illustrated in Fig. 2, the substrate 11 is a silicon on insulator (SOI) substrate including a base body 11a formed of a Si substrate, an insulating layer 11b on the base body 11a, and an SOI layer 11c on the insulating layer 11b, the SOI layer 11c being formed of a Si (100) film and including the principal surface 11p formed of a Si (100) plane.

The buffer film 12 is epitaxially grown on the principal surface 11p, is (100) oriented in a pseudo-cubic representation, and is made of a first metal oxide represented by the following composition formula (Chemical Formula 4).

(Hf₁₋ₓZrₓ)O₂... (Chemical Formula 4)

In the above composition formula (Chemical Formula 4), x satisfies 0 ≤ x < 1 or x = 1. Note that the above composition formula (Chemical Formula 4) is the same as the above composition formula (Chemical Formula 1). Further, instead of the first metal oxide represented by the above composition formula (Chemical Formula 4), a metal oxide represented by the composition formula (Chemical Formula 5) described later can also be used.

Note that in the specification of the present application, the expression that the metal oxide is (100) oriented in the pseudo-cubic representation means that the metal oxide has a cubic crystal structure at room temperature and is (100) oriented, or even when the metal oxide has a tetragonal or monoclinic crystal structure at room temperature, the metal oxide is (100) oriented when it undergoes phase transition at a high temperature to have a cubic crystal structure. Further, in the following, the first metal oxide represented by the above composition formula (Chemical Formula 4) is HfO₂ when x = 0, and is ZrO₂ when x = 1, but may be referred to as HZO when 0 < x < 1 is satisfied.

The metal film 13 is epitaxially grown on the buffer film 12 and is made of platinum (Pt). The metal film 13 has a cubic crystal structure and is (100) oriented. In other words, the metal film 13 is (100) oriented in a cubic representation.

The metal film 14 is epitaxially grown on the metal film 13 and contains iron (Fe), copper (Cu), molybdenum (Mo), tungsten (W), silver (Ag), aluminum (Al), titanium (Ti), or iridium (Ir) as a main component.

Patent Literature 1 discloses a technique in which a stainless steel thin film for a magnetic recording film contains Ni in an amount of 15 wt% or more and 24 wt% or less and Cr in an amount of 16.5 wt% or more and 19 wt% or less, and has a fine structure in which fine crystallites composed of a ferromagnetic phase and fine crystallites composed of a nonmagnetic phase are mixed by being grown on a base material by a vapor quenching method. However, in the technique described in Patent Literature 1, since a single-crystal-like stainless steel thin film cannot be formed on a substrate, it is difficult to improve the physical properties such as magnetization characteristics of the entire stainless steel thin film and to improve the smoothness of a film surface. Further, Patent Literature 2 discloses a technique of a laminated structure including at least a piezoelectric film and a metal film containing a metal as a main component, in which the metal is a metal that undergoes martensitic transformation by heat treatment or processing, and the metal contains Fe and Cr. However, in the technique described in Patent Literature 2, it is desirable to further improve the electrical conductivity of the entire film and to further improve the smoothness of a film surface in the metal film.

Further, Patent Literature 3 discloses a technique in which a method for forming a metal thin film includes a step of laminating a Cu thin film on a base, a step of annealing the Cu thin film, and a step of epitaxially growing a metal thin film on the Cu thin film. However, in the technique described in Patent Literature 3, when the Cu thin film laminated on the base is annealed, the Cu thin film is strongly oriented in a (111) plane because Cu has a face-centered cubic structure. As a result, since a single-crystal-like Cu thin film cannot be formed on the base, it is difficult to improve the physical properties such as electrical conductivity or thermal conductivity of the entire Cu thin film and to improve the smoothness of a film surface.

On the other hand, in the laminated structure according to the first embodiment, the metal film 14 is formed on the substrate 11 including a Si substrate or an SOI substrate via the buffer film 12 made of HfO₂, HZO, or ZrO₂ represented by the above composition formula (Chemical Formula 4) and the metal film 13 made of Pt. In such a laminated structure according to the first embodiment, in a case where the Si substrate is a Si (100) substrate or the SOI layer includes a Si (100) plane, the buffer film 12 made of HfO₂, HZO, or ZrO₂ represented by the above composition formula (Chemical Formula 4) is (100) oriented in the pseudo-cubic representation, and the metal film 13 tends to be (100) oriented in the cubic representation. Alternatively, in the laminated structure according to the first embodiment, the buffer film 12 made of HfO₂, HZO, or ZrO₂ represented by the above composition formula (Chemical Formula 4) is made of the first metal oxide epitaxially grown on the principal surface 11p of the substrate 11, the metal film 13 is made of Pt epitaxially grown on the buffer film 12, and the metal film 14 tends to be epitaxially grown on the metal film 13.

Therefore, according to the first embodiment, since the metal film 14 containing Fe as a main component, for example, containing stainless steel as a main component can be easily epitaxially grown on the metal film 13, a single-crystal-like stainless steel thin film can be easily formed on the substrate 11. Therefore, the homogeneity of the physical properties such as magnetization characteristics of the entire stainless steel thin film can be improved, and the smoothness of a film surface can be improved. Further, in a laminated structure including at least a piezoelectric film and a metal film containing a metal as a main component, the electrical conductivity of the entire film can be further improved, and the smoothness of a film surface can be further improved.

Further, according to the first embodiment, since the metal film 14 containing Cu as a main component can be easily epitaxially grown on the metal film 13, a single-crystal-like Cu film can be easily formed on the substrate 11. Therefore, the electrical conductivity of the entire Cu film can be improved, and the smoothness of a film surface can be improved.

Furthermore, according to the first embodiment, since the metal film 14 containing Mo, W, Ag, Al, Ti, or Ir as a main component can be easily epitaxially grown on the metal film 13, a single-crystal-like metal film 14 can be easily formed on the substrate 11. Therefore, the electrical conductivity of the entire metal film 14 containing Mo, W, Ag, Al, Ti, or Ir as a main component can be improved, and the smoothness of a film surface can be improved.

According to the first embodiment, the metal film 13 and the metal film 14 can be easily epitaxially grown on the substrate 11 including a Si substrate or an SOI substrate via the buffer film 12 made of HfO₂, HZO, or ZrO₂. This is considered to be due to, for example, a crystal growth mechanism in which a dynamic lattice matching effect caused by a twinning-type martensitic transformation exhibited by HfO₂, HZO, or ZrO₂, which is a main component of the buffer film 12, acts as a driving force, a motive force, and a propulsive force when the metal film 13 and the metal film 14 are epitaxially grown. However, the invention is not necessarily bound by such a theory.

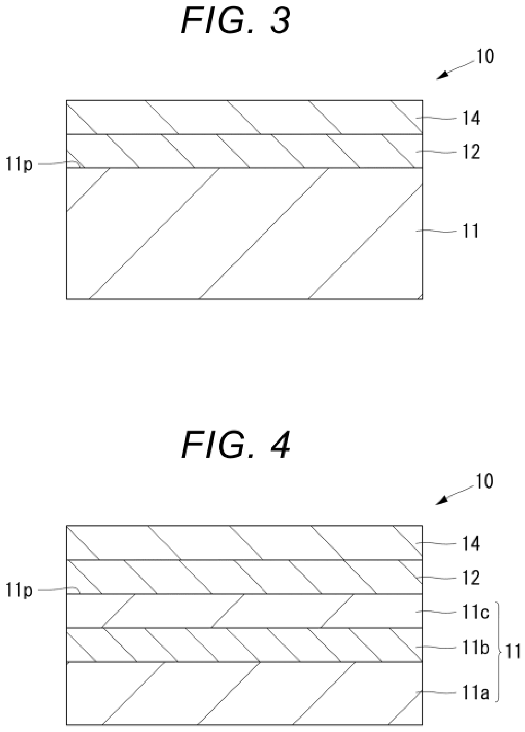

Note that in the laminated structure according to the first embodiment, the metal film 14 is formed on the substrate 11 via the buffer film 12 made of HfO₂, HZO, or ZrO₂ and the metal film 13 made of Pt. However, the laminated structure according to the first embodiment is not limited to the case where the metal film 14 is formed on the substrate 11 via the buffer film 12 made of HfO₂, HZO, or ZrO₂ and the metal film 13 made of Pt. Therefore, as illustrated in Figs. 3 and 4, in the laminated structure according to the first embodiment, the metal film 14 may be formed on the buffer film 12 made of HfO₂, HZO, or ZrO₂ without interposing the metal film 13 made of Pt therebetween.

Further, in the laminated structure according to the first embodiment, the buffer film 12 does not have to be made of the first metal oxide epitaxially grown on the principal surface 11p of the substrate 11, the metal film 13 does not have to be made of Pt epitaxially grown on the buffer film 12, and the metal film 14 does not have to be epitaxially grown on the metal film 13. Even in such a case, each crystal grain of the metal film 14 can be epitaxially grown on each crystal grain of the metal film 13. However, when the buffer film 12 is made of the first metal oxide epitaxially grown on the principal surface 11p of the substrate 11, the metal film 13 is made of Pt epitaxially grown on the buffer film 12, and the metal film 14 is epitaxially grown on the metal film 13, the metal film 14 can be easily epitaxially grown on the metal film 13.

Further, in the laminated structure according to the first embodiment, the substrate 11 does not have to be a Si (100) substrate including the principal surface 11p formed of a Si (100) plane or an SOI substrate including an SOI layer including the principal surface 11p formed of a Si (100) plane, the buffer film 12 does not have to be made of the first metal oxide that is (100) oriented in the pseudo-cubic representation, and the metal film 13 does not have to be (100) oriented in the cubic representation. However, when the substrate 11 is a Si (100) substrate including the principal surface 11p formed of a Si (100) plane or an SOI substrate including an SOI layer including the principal surface 11p formed of a Si (100) plane, the buffer film 12 is made of the first metal oxide that is (100) oriented in the pseudo-cubic representation, and the metal film 13 is (100) oriented in the cubic representation, the metal film 14 can be easily epitaxially grown on the metal film 13.

It is preferable that the metal film 14 contains Fe, has a cubic crystal structure, and is (100) oriented, that is, contains Fe, and is (100) oriented in the cubic representation. In such a case, it is preferable that the metal film 14 further contains Cr or Ni, whereby the metal film 14 can be a metal film made of stainless steel. In other words, it is preferable that the metal film 14 contains Fe or Cr, or Fe or Ni.

It is preferable that the metal film 14 contains Cu, has a cubic crystal structure, and is (100) oriented, that is, contains Cu, and is (100) oriented in the cubic representation. In such a case, since the metal film 14 containing Cu as a main component can be easily epitaxially grown on the metal film 13, a single-crystal-like Cu film can be easily formed on the substrate 11. Therefore, the electrical conductivity of the entire Cu film can be improved, and the smoothness of a film surface can be improved.

It is preferable that the metal film 14 contains Mo, has a cubic crystal structure, and is (110) oriented, that is, contains Mo, and is (110) oriented in the cubic representation. In such a case, since the piezoelectric film made of, for example, AlN can be easily formed on the metal film 14 in a state where the orientation of AlN is controlled, a piezoelectric element having the piezoelectric film can be easily formed.

It is preferable that the metal film 14 contains W, has a cubic crystal structure, and is (110) oriented, that is, contains W, and is (110) oriented in the cubic representation. In such a case, since the piezoelectric film made of, for example, AlN can be easily formed on the metal film 14 in a state where the orientation of AlN is controlled, a piezoelectric element having the piezoelectric film can be easily formed.

It is preferable that the metal film 14 contains Ag, has a cubic crystal structure, and is (100) oriented, that is, contains Ag, and is (100) oriented in the cubic representation. In such a case, since the metal film 14 containing Ag as a main component can be easily epitaxially grown on the metal film 13, a single-crystal-like Ag film can be easily formed on the substrate 11. Therefore, the electrical conductivity of the entire Ag film can be improved, and the smoothness of a film surface can be improved.

It is preferable that the metal film 14 contains Al, has a cubic crystal structure, and is (100) oriented, that is, contains Al, and is (100) oriented in the cubic representation. In such a case, since the metal film 14 containing Al as a main component can be easily epitaxially grown on the metal film 13, a single-crystal-like Al film can be easily formed on the substrate 11. Therefore, the electrical conductivity of the entire Al film can be improved, and the smoothness of a film surface can be improved.

It is preferable that the metal film 14 contains Ti, has a cubic crystal structure, and is (110) oriented, that is, contains Ti, and is (110) oriented in the cubic representation. In such a case, since the piezoelectric film made of, for example, AlN can be easily formed on the metal film 14 in a state where the orientation of AlN is controlled, a piezoelectric element having the piezoelectric film can be easily formed.

It is preferable that the metal film 14 contains Ir, has a cubic crystal structure, and is (100) oriented, that is, contains Ir, and is (100) oriented in the cubic representation. In such a case, since the metal film 14 containing Ir as a main component can be easily epitaxially grown on the metal film 13, a single-crystal-like Ir film can be easily formed on the substrate 11. Therefore, the electrical conductivity of the entire Ir film can be improved, and the smoothness of a film surface can be improved.

Note that when the metal film 14 contains Ir, it is preferable that the buffer film 12 is epitaxially grown on the principal surface 11p, is (100) oriented in the pseudo-cubic representation, and is made of a metal oxide represented by the following composition formula (Chemical Formula 5).

(Hf_{1-x-y-z}ZrₓY_{y}Al_{z})O₂₋ᵤ... (Chemical Formula 5)

In the above composition formula (Chemical Formula 5), x satisfies 0 ≤ x < 1, y satisfies 0 < y ≤ 0.3, and z satisfies 0 < z ≤ 0.3. In other words, the metal oxide represented by the above composition formula (Chemical Formula 5) is a metal oxide obtained by adding a metal oxide of one or more metals selected from the group consisting of Y and Al to the first metal oxide represented by the above composition formula (Chemical Formula 4), that is, HfO₂, HZO, or ZrO₂. In such a case, Ir contained in the metal film 14 has a cubic crystal structure, is (100) oriented, and tends to be epitaxially grown.

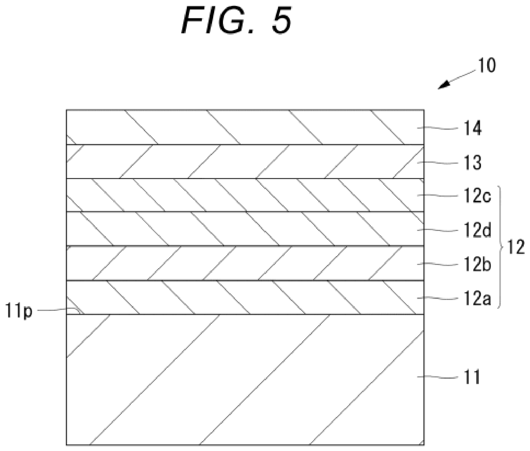

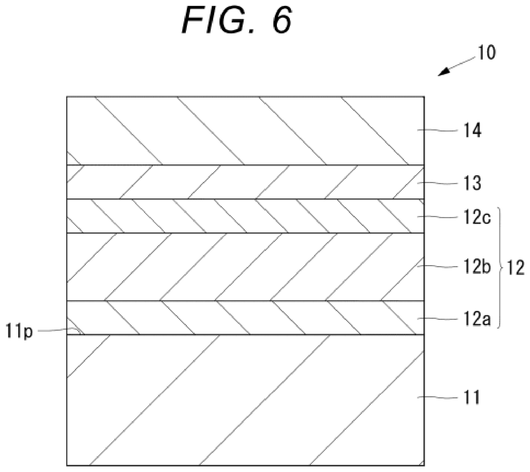

Figs. 5 and 6 are cross-sectional views illustrating other examples of the laminated structure according to the first embodiment. When the metal film 14 contains Ir, as illustrated in Figs. 5 and 6, the buffer film 12 preferably includes a buffer film (second buffer film) 12a formed on the principal surface 11p, a buffer film (third buffer film) 12b formed on the buffer film 12a, and a buffer film (fourth buffer film) 12c formed on the buffer film 12b.

The buffer film 12a is epitaxially grown on the principal surface 11p, is (100) oriented in the pseudo-cubic representation, and is made of a second metal oxide represented by the following composition formula (Chemical Formula 6).

(Hf_{1-x1-y1}Zrₓ₁M_{y1})O_{2-z1}... (Chemical Formula 6)

In the above composition formula (Chemical Formula 6), M is one or more selected from the group consisting of Nb, Ta, Si, Ti, a rare earth element, Al, and a Group 2 element, y1 satisfies 0 < y1 ≤ 0.3, and x1 satisfies 0 ≤ x1 ≤ 1 - y1. Note that the above composition formula (Chemical Formula 6) is the same as the above composition formula (Chemical Formula 2). Further, similarly to the buffer film 12, the buffer film 12a does not have to be epitaxially grown. Further, in the following, the second metal oxide represented by the above composition formula (Chemical Formula 6) may be referred to as yttria-stabilized zirconia (YSZ) when M is yttrium (Y) and x1 = 1, and may be referred to as yttria-stabilized hafnia (YSH) when M is Y and x1 = 0.

The buffer film 12b is epitaxially grown on the buffer film 12a, is (100) oriented in the pseudo-cubic representation, and is made of a third metal oxide represented by the following composition formula (Chemical Formula 7).

(REₓ₂Al_{y2})O_{z2}... (Chemical Formula 7)

In the above composition formula (Chemical Formula 7), RE is one or more selected from the group consisting of rare earth elements. Note that the above composition formula (Chemical Formula 7) is the same as the above composition formula (Chemical Formula 3). Further, similarly to the buffer film 12, the buffer film 12b does not have to be epitaxially grown.

The buffer film 12c is epitaxially grown on the buffer film 12b, is (100) oriented in the pseudo-cubic representation, and is made of a fourth metal oxide containing Ce. Note that similarly to the buffer film 12, the buffer film 12c does not have to be epitaxially grown.

In the technique described in Non Patent Literature 1, when an Ir (001) film is epitaxially grown on a Si substrate via a buffer film made of YSZ, it is necessary to grow the Ir (001) film at a low growth rate of about 0.05 nm/s. On the other hand, in the first embodiment, the buffer film 12b made of the third metal oxide, for example, YAlO₃, the buffer film 12c made of the fourth metal oxide including, for example, CeO₂, and the metal film 13 made of Pt are formed between the buffer film 12a made of the second metal oxide, for example, YSZ or YSH and the metal film 14 made of Ir. In such a case, the metal film 14 made of Ir can be epitaxially grown, and the growth rate of the metal film 14 can be greatly improved as compared with the growth rate of the metal film 14 in a case where the buffer film 12b, the buffer film 12c, and the metal film 13 are not formed between the buffer film 12a and the metal film 14.

When the metal film 14 contains Ir, as illustrated in Fig. 5, the buffer film 12 more preferably includes a buffer film (fifth buffer film) 12d formed on the buffer film 12b. The buffer film 12d is epitaxially grown on the buffer film 12b, is (100) oriented in the pseudo-cubic representation, and is made of the second metal oxide represented by the above composition formula (Chemical Formula 6) or the first metal oxide represented by the above composition formula (Chemical Formula 4). The buffer film 12c is epitaxially grown on the buffer film 12d. In such a case, it is possible to prevent the buffer film 12b made of the third metal oxide, for example, YAlO₃ from coming into contact with the buffer film 12c made of the fourth metal oxide made of, for example, CeO₂, making it easier for the metal film 14 made of Ir to be epitaxially grown. Note that similarly to the buffer film 12, the buffer film 12d does not have to be epitaxially grown.

Further, although not illustrated, the buffer film 12 includes the buffer film 12a, the buffer film 12b, and the buffer film 12d, but does not have to include the buffer film 12c. However, as described above, when the buffer film 12 includes the buffer film 12c, the metal film 14 made of Ir can be epitaxially grown, and the growth rate of the metal film 14 can be improved.

Further, the buffer film 12a made of the second metal oxide, for example, YSZ or YSH has a function of preventing the principal surface 11p of the substrate 11 from coming into contact with the buffer film 12b made of the third metal oxide, for example, YAlO₃, and the buffer film 12c made of the fourth metal oxide including, for example, CeO₂ has a function of preventing the buffer film 12b from coming into contact with the metal film 13 made of Pt. Therefore, as illustrated in Fig. 6, the film thickness of the buffer film 12a is preferably thinner than the film thickness of the buffer film 12b, and the film thickness of the buffer film 12c is preferably thinner than the film thickness of the buffer film 12b.

### <Modification of Laminated Structure>

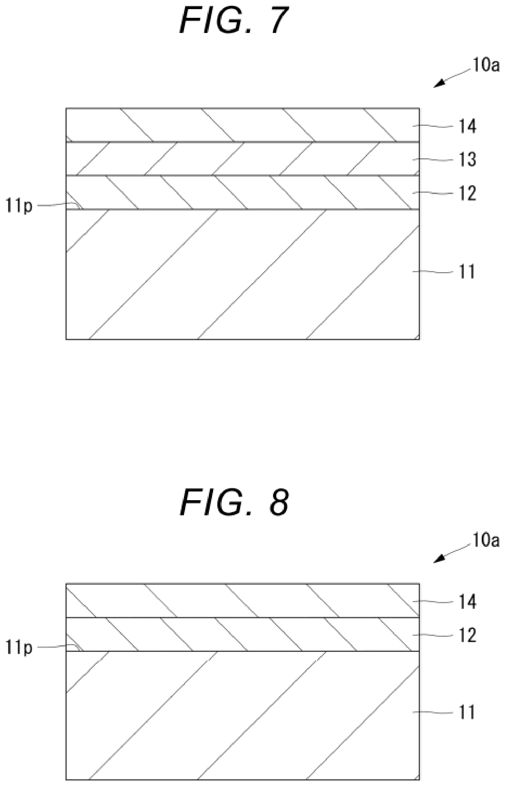

Next, a modification of the laminated structure according to the first embodiment will be described. A laminated structure according to the present modification is different from the laminated structure according to the first embodiment in that a substrate includes a Si (111) substrate or an SOI substrate including an SOI layer including a principal surface formed of a Si (111) plane. Fig. 7 is a cross-sectional view illustrating an example of the laminated structure according to the modification of the first embodiment. Fig. 8 is a cross-sectional view illustrating another example of the laminated structure according to the modification of the first embodiment.

Similarly to the laminated structure 10 illustrated in Figs. 1 and 2, a laminated structure 10a illustrated in Fig. 7 also includes the substrate 11 including the principal surface 11p, the buffer film 12 formed on the principal surface 11p, the metal film (second metal film) 13 formed on the buffer film 12, and the metal film (first metal film) 14 formed on the metal film (second metal film) 13.

On the other hand, in the example illustrated in Fig. 7, unlike the example illustrated in Fig. 1, the substrate 11 includes a Si (111) substrate including the principal surface 11p formed of a Si (111) plane. Further, although not illustrated, the substrate 11 may include an SOI substrate, similarly to the example illustrated in Fig. 2. In such a case, the substrate 11 is an SOI substrate including the base body 11a formed of a Si substrate, the insulating layer 11b on the base body 11a, and the SOI layer 11c on the insulating layer 11b, the SOI layer 11c being formed of a Si (111) film and including the principal surface 11p formed of a Si (111) plane.

The buffer film 12 is epitaxially grown on the principal surface 11p, is (111) oriented in the pseudo-cubic representation, and is made of the first metal oxide represented by the above composition formula (Chemical Formula 4). In the above composition formula (Chemical Formula 4), x satisfies 0 ≤ x < 1 or x = 1.

The metal film 13 is epitaxially grown on the buffer film 12 and is made of Pt. Pt contained in the metal film 13 has a cubic crystal structure and is (111) oriented. In other words, Pt contained in the metal film 13 is (100) oriented in the cubic representation.

The metal film 14 is epitaxially grown on the metal film 13 and contains Fe, Cu, Mo, W, Ag, Al, Ti, or Ir as a main component.

Also in the laminated structure according to the present modification, similarly to the laminated structure according to the first embodiment, the metal film 14 containing Fe, Cu, Mo, W, Ag, Al, Ti, or Ir as a main component can be easily epitaxially grown on the metal film 13, so that a single-crystal-like metal film 14 can be easily formed on the substrate 11. Therefore, the electrical conductivity of the entire metal film 14 containing Fe, Cu, Mo, W, Ag, Al, Ti, or Ir as a main component can be improved, and the smoothness of a film surface can be improved.

Note that also in the laminated structure according to the present modification, similarly to the laminated structure according to the first embodiment, as illustrated in Fig. 8, the metal film 14 may be formed on the buffer film 12 made of HfO₂, HZO, or ZrO₂ without interposing the metal film 13 made of Pt therebetween. Also in the laminated structure according to the present modification, similarly to the laminated structure according to the first embodiment, the buffer film 12 does not have to be made of the first metal oxide epitaxially grown on the principal surface 11p of the substrate 11, the metal film 13 does not have to be made of Pt epitaxially grown on the buffer film 12, and the metal film 14 does not have to be epitaxially grown on the metal film 13.

It is preferable that the metal film 14 contains Ir, has a cubic crystal structure, and is (111) oriented, that is, contains Ir, and is (111) oriented in the cubic representation. In such a case, since the metal film 14 containing Ir as a main component can be easily epitaxially grown on the metal film 13, a single-crystal-like Ir film can be easily formed on the substrate 11. Therefore, the electrical conductivity of the entire Ir film can be improved, and the smoothness of a film surface can be improved.

Note that when the metal film 14 contains Ir, it is preferable that the buffer film 12 is epitaxially grown on the principal surface 11p, is (111) oriented in the pseudo-cubic representation, and is made of the metal oxide represented by the above composition formula (Chemical Formula 5). In the above composition formula (Chemical Formula 5), x satisfies 0 ≤ x < 1, y satisfies 0 < y ≤ 0.3, and z satisfies 0 < z ≤ 0.3. In such a case, Ir contained in the metal film 14 has a cubic crystal structure, is (100) oriented, and tends to be epitaxially grown.

Also in the laminated structure according to the present modification, similarly to the laminated structure according to the first embodiment, when the metal film 14 contains Ir, as described with reference to Figs. 5 and 6 described above, the buffer film 12 preferably includes the buffer film (second buffer film) 12a formed on the principal surface 11p, the buffer film (third buffer film) 12b formed on the buffer film 12a, and the buffer film (fourth buffer film) 12c formed on the buffer film 12b, and has effects similar to those of the laminated structure according to the first embodiment. However, in the laminated structure according to the present modification, unlike the laminated structure according to the first embodiment, each of the buffer film 12a, the buffer film 12b, and the buffer film 12c is (111) oriented in the pseudo-cubic representation. Also in the laminated structure according to the present modification, similarly to the laminated structure according to the first embodiment, when the metal film 14 contains Ir, the buffer film 12 preferably includes the buffer film 12d, and has effects similar to those of the laminated structure according to the first embodiment. However, in the laminated structure according to the present modification, unlike the laminated structure according to the first embodiment, the buffer film 12d is (111) oriented in the pseudo-cubic representation.

### (Second Embodiment)

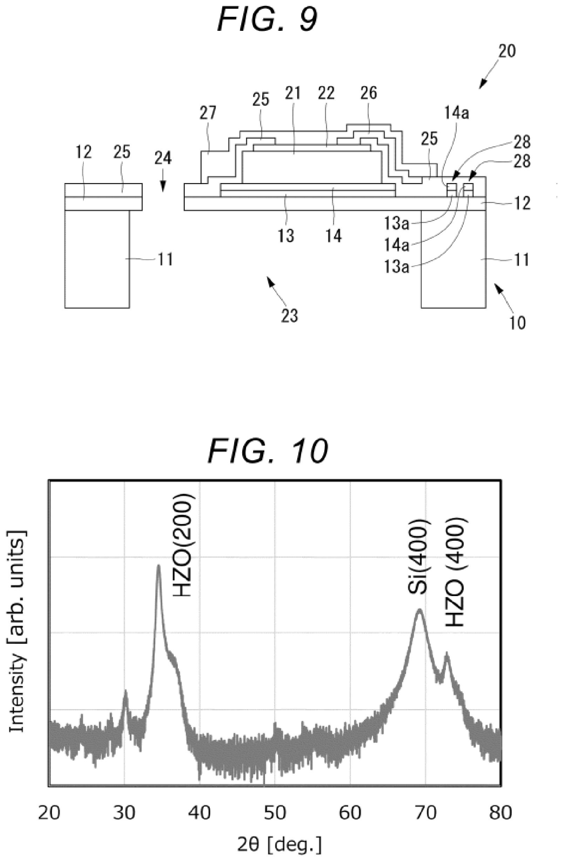

Next, an electronic device according to a second embodiment, which is an embodiment of the present invention, will be described. The electronic device according to the second embodiment is an inkjet print head as a fluid discharge device including the laminated structure 10 according to the first embodiment or the laminated structure 10a according to the modification of the first embodiment. Fig. 9 is a cross-sectional view of the electronic device according to the second embodiment.

As illustrated in Fig. 9, an electronic device 20 according to the second embodiment is an electronic device that includes the laminated structure 10 including the substrate 11 including a Si substrate, the buffer film 12 made of ZrO₂, HZO, or HfO₂, the metal film 13 made of Pt, and the metal film 14, in which the metal film 14 contains Fe, Cu, Mo, W, Ag, Al, Ti, or Ir as a main component.

Further, the electronic device 20 according to the second embodiment includes a piezoelectric film 21 formed on the metal film 14 and a metal film 22 formed on the piezoelectric film 21. In other words, the electronic device 20 according to the second embodiment is a piezoelectric actuator in which the metal film 13 and the metal film 14 function as a lower electrode, and the metal film 22 functions as an upper electrode. The piezoelectric film 21 is made of, for example, aluminum nitride (AlN) or lead zirconate titanate (PZT). The metal film 22 is made of, for example, platinum (Pt).

Further, the electronic device 20 according to the second embodiment includes a chamber 23 for accommodating a fluid. The chamber 23 is configured to take in a fluid from a tank (not illustrated) through a flow path 24.

The buffer film 12 as a dielectric layer is formed on the substrate 11 including a Si substrate, and the buffer film 12 faces the chamber 23. Since the buffer film 12 made of HZO or the like is used as the dielectric layer as described above, compared to a case where SiO₂, SiN, or the like is used as the dielectric layer, adhesion to the Si substrate and crystallinity are excellent, and further, piezoelectric characteristics and durability are also excellent.

The electronic device 20 according to the second embodiment further includes an insulator film 25, a conductive path 26, and a passivation film 27.

The insulator film 25 is formed on the lower electrode formed of the metal film 13 and the metal film 14, the piezoelectric film 21, and the upper electrode formed of the metal film 22. A material constituting the insulator film 25 is not particularly limited, but a dielectric material such as SiO₂, SiN, or Al₂O₃ can be used as the material constituting the insulator film 25. Further, the thickness of the insulator film 25 is not particularly limited, but is preferably a thickness between about 10 nm and about 10 µm.

The conductive path 26 is formed on the insulator film 25 and is electrically connected to the lower electrode formed of the metal film 13 and the metal film 14 and the upper electrode formed of the metal film 22, respectively, enabling selective access when the electronic device 20 is used. A material constituting the conductive path 26 is not particularly limited, but a conductive material such as aluminum (Al) can be used as the material constituting the conductive path 26.

The passivation film 27 is formed on the insulator film 25, the lower electrode formed of the metal film 13 and the metal film 14, the upper electrode formed of the metal film 22, and the conductive path 26. A material constituting the passivation film 27 is not particularly limited, but a dielectric material such as SiN or silicon oxynitrate (SION) can be used as the material constituting the passivation film 27. Further, the thickness of the passivation film 27 is not particularly limited, but is preferably a thickness between about 0.1 µm and about 3 µm.

The electronic device 20 according to the second embodiment includes a conductive pad 28 formed of a metal film 13a and a metal film 14a. Although not illustrated, the conductive pad 28 formed of the metal film 13a and the metal film 14a is electrically connected to the conductive path 26. The metal film 13a, together with the metal film 13, is epitaxially grown on the buffer film 12, is made of Pt, and is (100) oriented in the cubic representation. The metal film 14a, together with the metal film 14, is epitaxially grown on the metal film 13a, and contains iron (Fe), copper (Cu), molybdenum (Mo), tungsten (W), silver (Ag), aluminum (Al), titanium (Ti), or iridium (Ir) as a main component. Note that the insulator film 25 is formed on the conductive pad 28 formed of the metal film 13a and the metal film 14a.

According to the second embodiment, since the metal film 14a containing Fe, Cu, Mo, W, Ag, Al, Ti, or Ir as a main component can be easily epitaxially grown on the metal film 13a, a single-crystal-like metal film 14a can be easily formed on the substrate 11. Therefore, the electrical conductivity of the entire metal film 14a containing Fe, Cu, Mo, W, Cu, Ag, Al, Ti, or Ir as a main component can be improved, and the smoothness of a film surface can be improved. Therefore, the electrical characteristics of the piezoelectric actuator can be improved, for example, the power consumption of the piezoelectric actuator can be reduced.

Note that as described above, also in the laminated structure 10 included in the electronic device 20 according to the second embodiment, similarly to the laminated structure 10 according to the first embodiment, an SOI substrate that is a semiconductor substrate can be used as the substrate 11 instead of a Si substrate. Further, the electronic device including the laminated structure is not limited to a piezoelectric actuator, and various electronic devices such as a film bulk acoustic resonator (FBAR) can be exemplified.

### Examples

Hereinafter, the present invention will be described in more detail based on examples, but the present invention is not limited to the following examples.

### (Example 1)

### [Formation of Laminated Structure]

A laminated structure of Example 1 was produced. First, a crystal growth surface side of a Si substrate (100) was treated by reactive ion etching (RIE), and heated in the presence of oxygen to form a thermal oxide film, and then, metals (Hf, Zr) as vapor deposition sources and oxygen in the oxide film on the Si substrate were thermally reacted by a molecular beam epitaxy (MBE) method without using oxygen to form a single crystal film of the first metal oxide as the buffer film 12 (see Fig. 1) on the Si substrate. Next, oxygen was introduced, the temperature was lowered, and the pressure was increased to form a single crystal film of the first metal oxide as the buffer film 12 (see Fig. 1) by the MBE method. Note that the conditions of the MBE method during this film formation were as follows. Further, the value of Hf : Zr (atomic ratio, the same applies hereinafter) was a target value of 25 : 75 (x in the above composition formula (Chemical Formula 4) was 0.75).
Vapor deposition source: Hf, Zr
Voltage: 3.5 to 4.75 V
Pressure: 3 × 10⁻² to 6 × 10⁻² Pa
Substrate temperature: 450 to 700°C

Next, a metal film of platinum (Pt) was formed as the metal film 13 on the single crystal film of the first metal oxide as the buffer film 12 by a sputtering method. The conditions at this time are shown below.
Apparatus: Sputtering apparatus QAM-4 manufactured by ULVAC, Inc.
Pressure: 1.20 × 10⁻¹ Pa
Target: Pt
Power: 100 W (DC)
Thickness: 100 nm
Substrate temperature: 450 to 600°C

Next, the metal film 14 made of FeNiCr was formed on the metal film 13 by a vapor deposition method. In a step of forming the metal film 14 made of FeNiCr, first, Fe and Ni were deposited. The conditions for depositing Fe and Ni are shown below.
Vapor deposition source: Fe, Ni
Pressure: 4 × 10⁻⁴ Pa
Substrate temperature: 100 to 500°C
Film thickness: 100 nm

In the step of forming the metal film 14, next, Cr was deposited on the uppermost surface of the metal film 14 to form the metal film 14. The conditions for depositing Cr are shown below.
Vapor deposition source: Cr
Pressure: 4 × 10⁻⁴ Pa
Substrate temperature: 100 to 500°C
Film thickness: 20 nm

In this way, the metal film 14 made of FeNiCr was formed on the buffer film 12 via the metal film 13 by the vapor deposition method to produce the laminated structure of Example 1. Note that as described with reference to Fig. 3 described above, the metal film 13 does not have to be formed between the buffer film 12 and the metal film 14, and the metal film 14 may be formed on the buffer film 12 without interposing the metal film 13 therebetween.

### [X-Ray Diffraction Measurement]

After the buffer film 12 was formed on the principal surface 11p of the substrate 11 and before the metal film 13 was formed, the diffraction pattern of the laminated structure was measured by X-ray diffraction (XRD) measurement using the θ-2θ method in a state where the laminated structure was disposed such that a diffraction surface in the X-ray diffraction measurement was parallel to the principal surface 11p. Fig. 10 illustrates the measured diffraction pattern of the laminated structure of Example 1. Note that the X-ray diffraction measurement was performed using an X-ray diffractometer SmartLab manufactured by Rigaku Holdings Corporation.

As illustrated in Fig. 10, in the diffraction pattern, a strong diffraction peak of a (200) plane of HZO, which is composed of a (200) plane of tetragonal ZrO₂ and a (200) plane of monoclinic HfO₂, was observed. Therefore, it has become clear that HZO contained in the first metal oxide is (100) oriented in the pseudo-cubic representation.

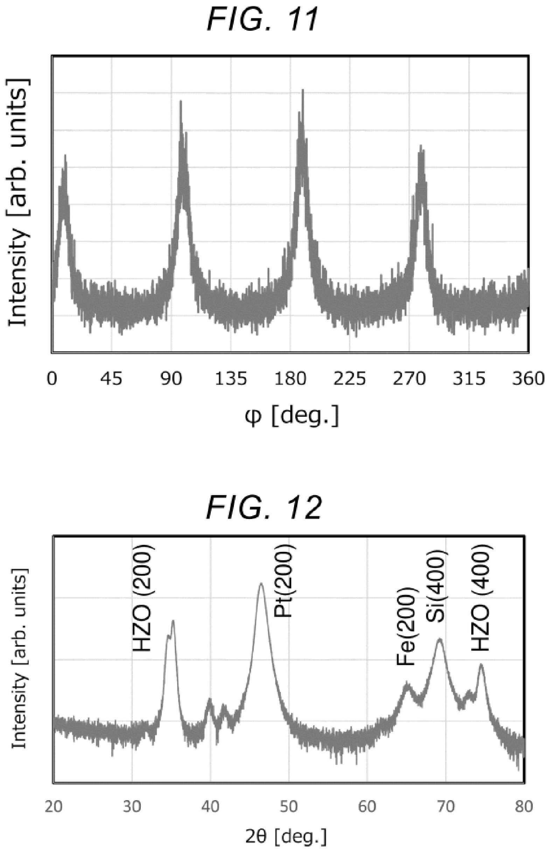

Further, a φ scan was performed on a (220) plane (2θ = 50°) of HZO contained in the first metal oxide in a state where the laminated structure was disposed such that the diffraction surface in the X-ray diffraction measurement was inclined at 45° relative to the principal surface 11p. The φ scan measured for the laminated structure of Example 1 is illustrated in Fig. 11.

As illustrated in Fig. 11, in the φ scan, four strong diffraction peaks of the (220) plane of HZO were observed every 90°. In other words, in the φ scan, diffraction peaks showing fourfold symmetry of HZO were observed. Therefore, it has become clear that the crystal axes of HZO contained in the first metal oxide are aligned also in an in-plane direction along the principal surface 11p of the substrate 11, that is, the HZO is epitaxially grown.

Further, after the metal film 13 and the metal film 14 were formed, the diffraction pattern of the obtained laminated structure of Example 1 was measured by the X-ray diffraction measurement using the θ-2θ method in a state where the laminated structure was disposed such that the diffraction surface of the laminated structure of Example 1 in the X-ray diffraction measurement was parallel to the principal surface 11p. Fig. 12 illustrates the measured diffraction pattern of the laminated structure of Example 1.

As illustrated in Fig. 12, in the diffraction pattern of Example 1, a strong diffraction peak of a (200) plane of Pt and a strong diffraction peak of a (200) plane of FeNiCr were observed. Therefore, in Example 1, it has become clear that Pt contained in the metal film 13 is (200) oriented, and FeNiCr contained in the metal film 14 is (200) oriented. Note that in Fig. 12, the (200) plane of FeNiCr is described as Fe (200).

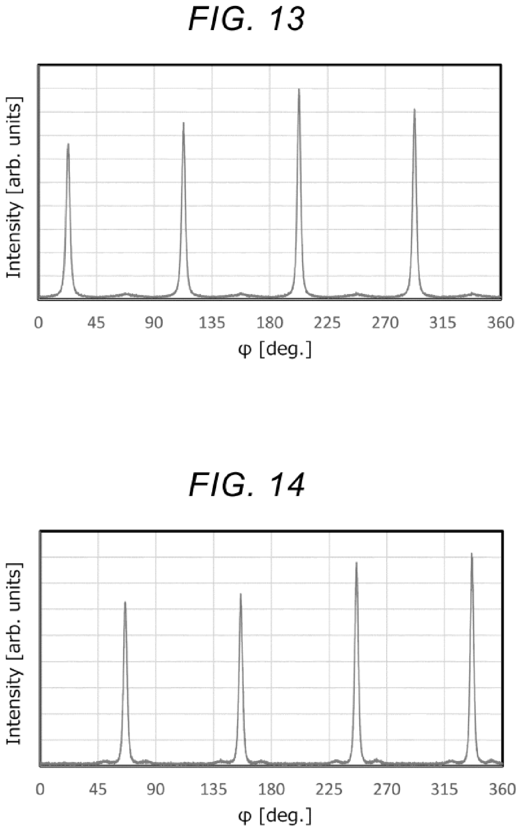

Further, a φ scan was performed on the (200) plane (2θ = 46°) of Pt in a state (in-plane measurement) where the laminated structure was disposed such that the diffraction surface in the X-ray diffraction measurement was inclined at 90° relative to the principal surface 11p. The measured φ scan is illustrated in Fig. 13.

As illustrated in Fig. 13, in the φ scan, four strong diffraction peaks of the (200) plane of Pt were observed every 90°. In other words, in the φ scan, diffraction peaks showing fourfold symmetry of Pt were observed. Therefore, it has become clear that the crystal axes of Pt contained in the metal film 13 are aligned also in the in-plane direction along the principal surface 11p of the substrate 11, that is, the Pt is epitaxially grown.

Further, a φ scan was performed on a (110) plane (2θ = 45°) of FeNiCr in a state where the laminated structure was disposed such that the diffraction surface in the X-ray diffraction measurement was inclined at 45° relative to the principal surface 11p. The measured φ scan is illustrated in Fig. 14.

As illustrated in Fig. 14, in the φ scan, four strong diffraction peaks of the (110) plane of FeNiCr were observed every 90°. In other words, in the φ scan, diffraction peaks showing fourfold symmetry of FeNiCr were observed. Therefore, it has become clear that the crystal axes of FeNiCr contained in the metal film 14 are aligned also in the in-plane direction along the principal surface 11p of the substrate 11, that is, the FeNiCr is epitaxially grown.

Note that although detailed description is omitted, also in a case where the metal film 13 made of Pt is not formed between the buffer film 12 and the metal film 14, a strong diffraction peak of the (200) plane of FeNiCr was observed in the diffraction pattern by the X-ray diffraction measurement using the θ-2θ method, and it has become clear that FeNiCr contained in the metal film 14 is (200) oriented. Further, in the φ scan of the (110) plane of FeNiCr, diffraction peaks showing fourfold symmetry were observed, and it has become clear that FeNiCr contained in the metal film 14 is epitaxially grown.

Further, although detailed description is omitted, also in a case where the ratio of Hf : Zr is other than 25 : 75 and x in the above composition formula (Chemical Formula 4) satisfies 0 ≤ x < 1 or x satisfies x = 1, results similar to those in Example 1 in which the ratio of Hf : Zr is 25 : 75 (x in the above composition formula (Chemical Formula 4) is 0.75) were obtained.

### (Example 2)

### [Formation of Laminated Structure]

Next, a laminated structure of Example 2 was produced in exactly the same manner as in Example 1 except that the metal film 14 made of Cu was formed on the buffer film 12 (see Fig. 1) by the vapor deposition method.

In Example 2, as in Example 1, after the buffer film 12 and the metal film 13 were formed, the metal film 14 made of Cu was formed on the metal film 13 by the vapor deposition method. In a step of forming the metal film 14 made of Cu, Cu was deposited. The conditions for depositing Cu are shown below.
Vapor deposition source: Cu
Pressure: 4 × 10⁻⁴ Pa
Substrate temperature: 100 to 500°C
Film thickness: 120 nm

In this way, the metal film 14 made of Cu was formed on the metal film 13 by the vapor deposition method to produce the laminated structure of Example 2. Note that as described with reference to Fig. 3 described above, the metal film 13 does not have to be formed between the buffer film 12 and the metal film 14, and the metal film 14 may be formed on the buffer film 12 without interposing the metal film 13 therebetween.

### [X-Ray Diffraction Measurement]

After the buffer film 12 was formed on the principal surface 11p of the substrate 11 and before the metal film 13 was formed, the diffraction pattern of the laminated structure was measured by the X-ray diffraction measurement using the θ-2θ method in a state where the laminated structure was disposed such that a diffraction surface in the X-ray diffraction measurement was parallel to the principal surface 11p. As the measured diffraction pattern, results similar to those illustrated in Fig. 10 in Example 1 were obtained, and it has become clear that HZO contained in the first metal oxide is (100) oriented in the pseudo-cubic representation.

Further, a φ scan was performed on a (220) plane (2θ = 50°) of HZO contained in the first metal oxide. In the φ scan, results similar to those illustrated in Fig. 11 in Example 1 were obtained, and it has become clear that the crystal axes of HZO contained in the first metal oxide are aligned also in the in-plane direction along the principal surface 11p of the substrate 11, that is, the HZO is epitaxially grown.

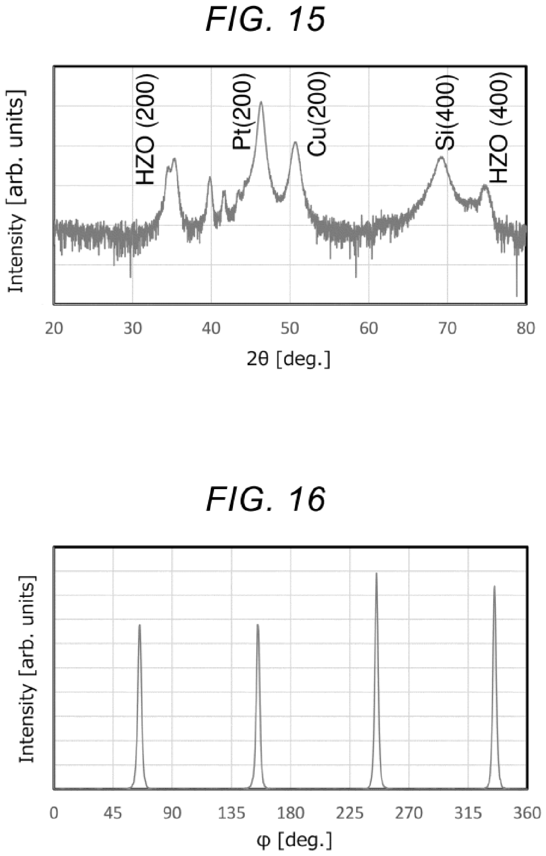

Further, after the metal film 13 and the metal film 14 were formed, the diffraction pattern of the obtained laminated structure of Example 2 was measured by the X-ray diffraction measurement using the θ-2θ method in a state where the laminated structure was disposed such that the diffraction surface of the laminated structure of Example 2 in the X-ray diffraction measurement was parallel to the principal surface 11p. Fig. 15 illustrates the measured diffraction pattern of the laminated structure of Example 2.

As illustrated in Fig. 15, in the measured diffraction pattern of Example 2, a strong diffraction peak of a (200) plane of Pt and a strong diffraction peak of a (200) plane of Cu were observed. Therefore, in Example 2, it has become clear that Pt contained in the metal film 13 is (200) oriented, and Cu contained in the metal film 14 is (200) oriented.

Further, a φ scan was performed on the (200) plane (2θ = 46°) of Pt contained in the metal film 13. In the φ scan, results similar to those illustrated in Fig. 13 in Example 1 were obtained, and it has become clear that the crystal axes of Pt contained in the metal film 13 are aligned also in the in-plane direction along the principal surface 11p of the substrate 11, that is, the Pt is epitaxially grown.

Further, a φ scan was performed on the (200) plane (2θ = 50°) of Cu in a state where the laminated structure was disposed such that the diffraction surface in the X-ray diffraction measurement was inclined at 90° relative to the principal surface 11p (see Fig. 1). The measured φ scan is illustrated in Fig. 16.

As illustrated in Fig. 16, in the φ scan, four strong diffraction peaks of the (200) plane of Cu were observed every 90°. In other words, in the φ scan, diffraction peaks showing fourfold symmetry of Cu were observed. Therefore, it has become clear that the crystal axes of Cu contained in the metal film 14 are aligned also in the in-plane direction along the principal surface 11p of the substrate 11, that is, the Cu is epitaxially grown.

Note that although detailed description is omitted, also in a case where the metal film 13 made of Pt is not formed between the buffer film 12 and the metal film 14, a strong diffraction peak of the (200) plane of Cu was observed in the diffraction pattern by the X-ray diffraction measurement using the θ-2θ method, and it has become clear that Cu contained in the metal film 14 is (200) oriented. Further, in the φ scan of the (200) plane of Cu, diffraction peaks showing fourfold symmetry were observed, and it has become clear that Mo contained in the metal film 14 is epitaxially grown.

Further, although detailed description is omitted, also in a case where x in the above composition formula (Chemical Formula 4) satisfies 0 ≤ x < 1 or x satisfies x = 1, results similar to those in Example 2 in which the ratio of Hf : Zr is 25 : 75 (x in the above composition formula (Chemical Formula 4) is 0.75) were obtained.

### (Example 3)

### [Formation of Laminated Structure]

Next, a laminated structure of Example 3 was produced in exactly the same manner as in Example 1 except that the metal film 14 made of Mo was formed on the buffer film 12 by the vapor deposition method.

In Example 3, as in Example 1, after the buffer film 12 was formed, the metal film 14 made of Mo was formed on the buffer film 12 by the vapor deposition method. In a step of forming the metal film 14 made of Mo, Mo was deposited. The conditions for depositing Mo are shown below.
Vapor deposition source: Mo
Pressure: 4 × 10⁻⁴ Pa
Substrate temperature: 100 to 500°C
Film thickness: 120 nm

In this way, the metal film 14 made of Mo was formed on the metal film 13 by the vapor deposition method to produce the laminated structure of Example 3. Note that as described with reference to Fig. 3 described above, the metal film 13 does not have to be formed between the buffer film 12 and the metal film 14, and the metal film 14 may be formed on the buffer film 12 without interposing the metal film 13 therebetween.

### [X-Ray Diffraction Measurement]

After the buffer film 12 was formed on the principal surface 11p of the substrate 11 and before the metal film 13 was formed, the diffraction pattern of the laminated structure was measured by the X-ray diffraction measurement using the θ-2θ method in a state where the laminated structure was disposed such that a diffraction surface in the X-ray diffraction measurement was parallel to the principal surface 11p. As the measured diffraction pattern, results similar to those illustrated in Fig. 10 in Example 1 were obtained, and it has become clear that HZO contained in the first metal oxide is (100) oriented in the pseudo-cubic representation.

Further, a φ scan was performed on a (220) plane (2θ = 50°) of HZO contained in the first metal oxide. In the φ scan, results similar to those illustrated in Fig. 11 in Example 1 were obtained, and it has become clear that the crystal axes of HZO contained in the first metal oxide are aligned also in the in-plane direction along the principal surface 11p of the substrate 11, that is, the HZO is epitaxially grown.

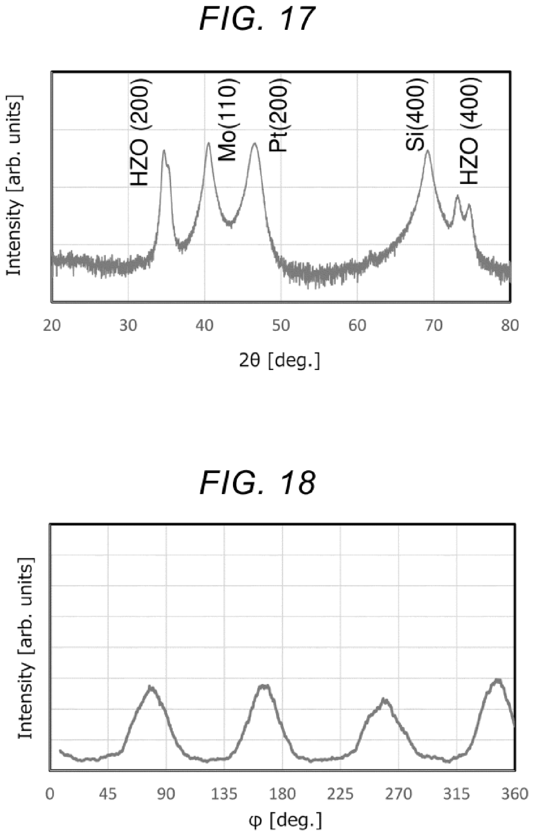

Further, after the metal film 13 and the metal film 14 were formed, the diffraction pattern of the obtained laminated structure of Example 3 was measured by the X-ray diffraction measurement using the θ-2θ method in a state where the laminated structure was disposed such that the diffraction surface of the laminated structure of Example 3 in the X-ray diffraction measurement was parallel to the principal surface 11p. Fig. 17 illustrates the measured diffraction pattern of the laminated structure of Example 3.

As illustrated in Fig. 17, in the measured diffraction pattern of Example 3, a strong diffraction peak of a (200) plane of Pt and a strong diffraction peak of a (110) plane of Mo were observed. Therefore, in Example 3, it has become clear that Pt contained in the metal film 13 is (200) oriented, and Mo contained in the metal film 14 is (110) oriented.

Further, a φ scan was performed on the (200) plane (2θ = 46°) of Pt contained in the metal film 13. In the φ scan, results similar to those illustrated in Fig. 13 in Example 1 were obtained, and it has become clear that the crystal axes of Pt contained in the metal film 13 are aligned also in the in-plane direction along the principal surface 11p of the substrate 11, that is, the Pt is epitaxially grown.

Further, a φ scan was performed on a (200) plane (2θ = 59°) of Mo in a state where the laminated structure was disposed such that the diffraction surface in the X-ray diffraction measurement was inclined at 45° relative to the principal surface 11p (see Fig. 1). The measured φ scan is illustrated in Fig. 18.

As illustrated in Fig. 18, in the φ scan, four strong diffraction peaks of the (200) plane of Mo were observed every 90°. In other words, in the φ scan, diffraction peaks showing apparent fourfold symmetry of Mo were observed. Therefore, it has become clear that the crystal axes of Mo contained in the metal film 14 are aligned also in the in-plane direction along the principal surface 11p of the substrate 11, that is, the Mo is epitaxially grown. Note that in a case where Mo is (110) oriented and is composed of a single domain, it is expected that two strong diffraction peaks of the (200) plane of Mo are observed every 180° in the φ scan of the (200) plane of Mo. On the other hand, the results illustrated in Fig. 18 show that the φ scan has two diffraction peak groups spaced 90° apart from each other, and each of the two diffraction peak groups includes two diffraction peaks spaced 180° apart from each other. Therefore, it is considered that Mo has two types of domains including a first domain that is (110) oriented and a second domain that is (110) oriented and rotated by 90° relative to the first domain within the principal surface.

Note that although detailed description is omitted, also in a case where the metal film 13 made of Pt is not formed between the buffer film 12 and the metal film 14, a strong diffraction peak of the (110) plane of Mo was observed in the diffraction pattern by the X-ray diffraction measurement using the θ-2θ method, and it has become clear that Mo contained in the metal film 14 is (110) oriented. Further, in the φ scan of the (200) plane of Mo, four diffraction peaks were observed, and it has become clear that Mo contained in the metal film 14 is epitaxially grown.

Further, although detailed description is omitted, also in a case where x in the above composition formula (Chemical Formula 4) satisfies 0 ≤ x < 1 or x satisfies x = 1, results similar to those in Example 3 in which the ratio of Hf : Zr is 25 : 75 (x in the above composition formula (Chemical Formula 4) is 0.75) were obtained.

### (Example 4)

### [Formation of Laminated Structure]

Next, a laminated structure of Example 4 was produced in exactly the same manner as in Example 1 except that the metal film 14 made of W was formed on the buffer film 12 by the vapor deposition method.

In Example 4, as in Example 1, after the buffer film 12 and the metal film 13 were formed, the metal film 14 made of W was formed on the metal film 13 by the vapor deposition method. In a step of forming the metal film 14 made of W, W was deposited. The conditions for depositing W are shown below.
Vapor deposition source: W
Pressure: 4 × 10⁻⁴ Pa
Substrate temperature: 100 to 500°C
Film thickness: 120 nm

In this way, the metal film 14 made of W was formed on the metal film 13 by the vapor deposition method to produce the laminated structure of Example 4. Note that as described with reference to Fig. 3 described above, the metal film 13 does not have to be formed between the buffer film 12 and the metal film 14, and the metal film 14 may be formed on the buffer film 12 without interposing the metal film 13 therebetween.

### [X-Ray Diffraction Measurement]

After the buffer film 12 was formed on the principal surface 11p of the substrate 11 and before the metal film 13 was formed, the diffraction pattern of the laminated structure was measured by the X-ray diffraction measurement using the θ-2θ method in a state where the laminated structure was disposed such that a diffraction surface in the X-ray diffraction measurement was parallel to the principal surface 11p. As the measured diffraction pattern, results similar to those illustrated in Fig. 10 in Example 1 were obtained, and it has become clear that HZO contained in the first metal oxide is (100) oriented in the pseudo-cubic representation.

Further, a φ scan was performed on a (220) plane (2θ = 50°) of HZO contained in the first metal oxide. In the φ scan, results similar to those illustrated in Fig. 11 in Example 1 were obtained, and it has become clear that the crystal axes of HZO contained in the first metal oxide are aligned also in the in-plane direction along the principal surface 11p of the substrate 11, that is, the HZO is epitaxially grown.

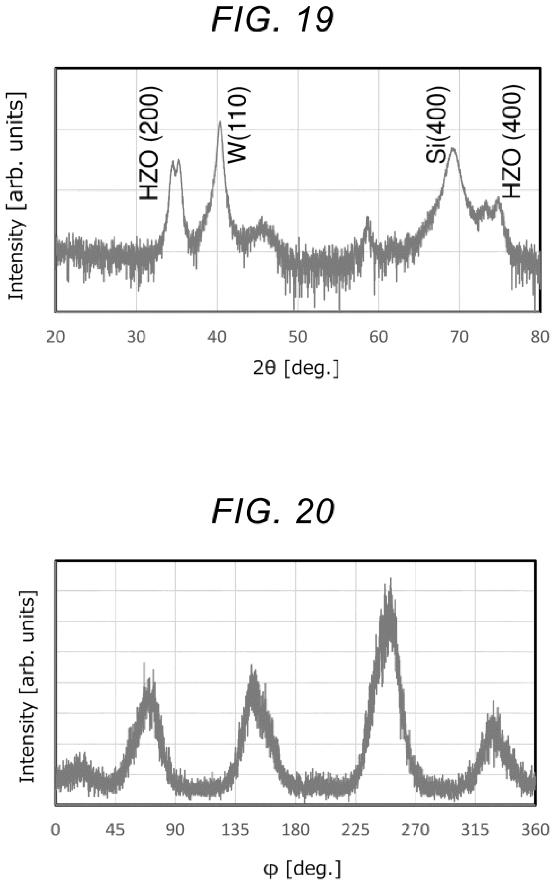

Further, after the metal film 13 and the metal film 14 were formed, the diffraction pattern of the obtained laminated structure of Example 4 was measured by the X-ray diffraction measurement using the θ-2θ method in a state where the laminated structure was disposed such that the diffraction surface of the laminated structure of Example 4 in the X-ray diffraction measurement was parallel to the principal surface 11p. Fig. 19 illustrates the measured diffraction pattern of the laminated structure of Example 4.

As illustrated in Fig. 19, in the measured diffraction pattern of Example 4, a diffraction peak of a (200) plane of Pt and a strong diffraction peak of a (110) plane of W were observed. Therefore, in Example 4, it has become clear that Pt contained in the metal film 13 is (200) oriented, and W contained in the metal film 14 is (110) oriented.

Further, a φ scan was performed on the (200) plane (2θ = 46°) of Pt contained in the metal film 13. In the φ scan, results similar to those illustrated in Fig. 13 in Example 1 were obtained, and it has become clear that the crystal axes of Pt contained in the metal film 13 are aligned also in the in-plane direction along the principal surface 11p of the substrate 11, that is, the Pt is epitaxially grown.

Further, a φ scan was performed on the (110) plane (2θ = 40°) of W in a state (in-plane measurement) where the laminated structure was disposed such that the diffraction surface in the X-ray diffraction measurement was inclined at 90° relative to the principal surface 11p (see Fig. 1). The measured φ scan is illustrated in Fig. 20.

As illustrated in Fig. 20, in the φ scan, four strong diffraction peaks of the (110) plane of W were observed every 90°. In other words, in the φ scan, diffraction peaks showing apparent fourfold symmetry of W were observed. Therefore, it has become clear that the crystal axes of W contained in the metal film 14 are aligned also in the in-plane direction along the principal surface 11p of the substrate 11, that is, the W is epitaxially grown. Note that in a case where W is (110) oriented and is composed of a single domain, it is expected that two strong diffraction peaks of the (110) plane of W are observed every 180° in the φ scan of the (110) plane of W. On the other hand, the results illustrated in Fig. 20 show that the φ scan has two diffraction peak groups spaced 90° apart from each other, and each of the two diffraction peak groups includes two diffraction peaks spaced 180° apart from each other. Therefore, it is considered that W has two types of domains including a first domain that is (110) oriented and a second domain that is (110) oriented and rotated by 90° relative to the first domain within the principal surface.

Note that although detailed description is omitted, also in a case where the metal film 13 made of Pt is not formed between the buffer film 12 and the metal film 14, a strong diffraction peak of the (110) plane of W was observed in the diffraction pattern by the X-ray diffraction measurement using the θ-2θ method, and it has become clear that W contained in the metal film 14 is (110) oriented. Further, in the φ scan of the (110) plane of W, four diffraction peaks were observed, and it has become clear that W contained in the metal film 14 is epitaxially grown.

Further, although detailed description is omitted, also in a case where x in the above composition formula (Chemical Formula 4) satisfies 0 ≤ x < 1 or x satisfies x = 1, results similar to those in Example 4 in which the ratio of Hf : Zr is 25 : 75 (x in the above composition formula (Chemical Formula 4) is 0.75) were obtained.

Further, although detailed description is omitted, also in a case where the metal film 14 made of Ti was formed instead of the metal film 14 made of W, results similar to those in a case where the metal film 14 made of W was formed were obtained.

### (Example 5)

### [Formation of Laminated Structure]

Next, a laminated structure of Example 5 was produced in exactly the same manner as in Example 1 except that the metal film 14 made of Ag was formed on the buffer film 12 by the vapor deposition method.

In Example 5, after the buffer film 12 and the metal film 13 were formed, unlike Example 1, the metal film 14 made of Ag was formed on the metal film 13 by the vapor deposition method. The conditions for depositing Ag are shown below.
Vapor deposition source: Ag
Pressure: 4 × 10⁻⁴ Pa
Substrate temperature: 100 to 500°C
Film thickness: 120 nm

Note that as described with reference to Fig. 3 described above, the metal film 13 does not have to be formed between the buffer film 12 and the metal film 14, and the metal film 14 may be formed on the buffer film 12 without interposing the metal film 13 therebetween.

### [X-Ray Diffraction Measurement]

After the buffer film 12 was formed on the principal surface 11p of the substrate 11 and before the metal film 13 was formed, the diffraction pattern was measured by the X-ray diffraction measurement using the θ-2θ method in a state where the laminated structure was disposed such that a diffraction surface in the X-ray diffraction measurement was parallel to the principal surface 11p. As the measured diffraction pattern, results similar to those illustrated in Fig. 10 in Example 1 were obtained, and it has become clear that HZO contained in the first metal oxide is (100) oriented in the pseudo-cubic representation.

Further, in a φ scan of a (220) plane (2θ = 50°) of HZO contained in the first metal oxide, results similar to those illustrated in Fig. 11 in Example 1 were obtained, and it has become clear that the crystal axes of HZO contained in the first metal oxide are aligned also in the in-plane direction along the principal surface 11p of the substrate 11, that is, the HZO is epitaxially grown.

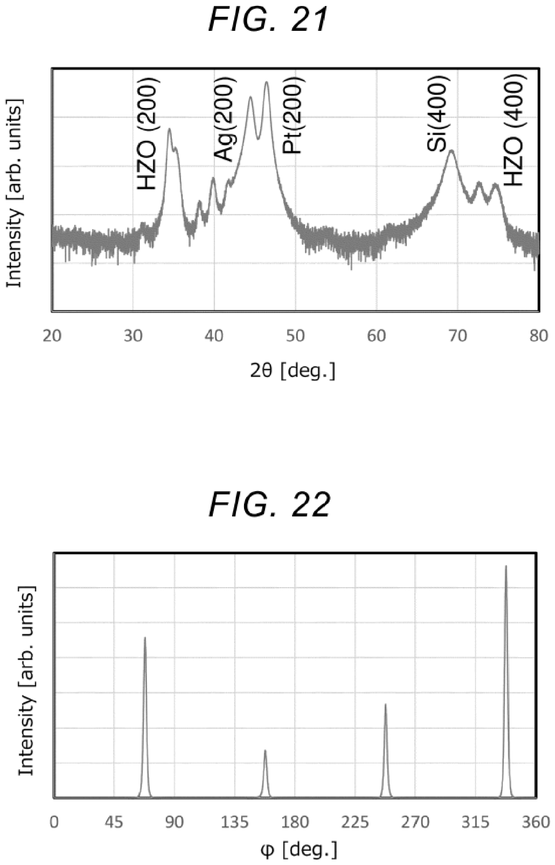

Further, after the metal film 13 and the metal film 14 were formed, the diffraction pattern of the obtained laminated structure of Example 5 was measured by the X-ray diffraction measurement using the θ-2θ method in a state where the laminated structure was disposed such that the diffraction surface of the laminated structure of Example 5 in the X-ray diffraction measurement was parallel to the principal surface 11p. Fig. 21 illustrates the measured diffraction pattern of the laminated structure of Example 5.

As illustrated in Fig. 21, in the measured diffraction pattern of Example 5, a strong diffraction peak of a (200) plane of Pt and a strong diffraction peak of a (200) plane of Ag were observed. Therefore, in Example 5, it has become clear that Pt contained in the metal film 13 is (200) oriented, and Ag contained in the metal film 14 is (100) oriented.

Further, a φ scan was performed on the (200) plane (2θ = 46°) of Pt contained in the metal film 13. In the φ scan, results similar to those illustrated in Fig. 13 in Example 1 were obtained, and it has become clear that the crystal axes of Pt contained in the metal film 13 are aligned also in the in-plane direction along the principal surface 11p of the substrate 11, that is, the Pt is epitaxially grown.

Further, a φ scan was performed on a (220) plane (2θ = 64°) of Ag in a state where the laminated structure was disposed such that the diffraction surface in the X-ray diffraction measurement was inclined at 45° relative to the principal surface 11p. The measured φ scan is illustrated in Fig. 22.

As illustrated in Fig. 22, in the φ scan, four strong diffraction peaks of the (220) plane of Ag were observed every 90°. In other words, in the φ scan, diffraction peaks showing fourfold symmetry of Ag were observed. Therefore, it has become clear that the crystal axes of Ag contained in the metal film 14 are aligned also in the in-plane direction along the principal surface 11p of the substrate 11, that is, the Ag is epitaxially grown.

Note that although detailed description is omitted, also in a case where the metal film 13 made of Pt is not formed between the buffer film 12 and the metal film 14, a strong diffraction peak of the (200) plane of Ag was observed in the diffraction pattern by the X-ray diffraction measurement using the θ-2θ method, and it has become clear that Ag contained in the metal film 14 is (100) oriented. Further, in the φ scan of the (220) plane of Ag, diffraction peaks showing fourfold symmetry were observed, and it has become clear that W contained in the metal film 14 is epitaxially grown.

Further, although detailed description is omitted, also in a case where x in the above composition formula (Chemical Formula 4) satisfies 0 ≤ x < 1 or x satisfies x = 1, results similar to those in Example 5 in which the ratio of Hf : Zr is 25 : 75 (x in the above composition formula (Chemical Formula 4) is 0.75) were obtained.

Further, although detailed description is omitted, also in a case where the metal film 14 made of Al was formed instead of the metal film 14 made of Ag, results similar to those in a case where the metal film 14 made of Ag was formed were obtained.

### (Example 6)

### [Formation of Laminated Structure]

Next, the metal film 14 made of Ir was formed on the buffer film 12 to produce a laminated structure of Example 6.

First, a crystal growth surface side of a Si substrate (100) was treated by RIE, and heated in the presence of oxygen to form a thermal oxide film, and then, metals (Hf, Zr) as vapor deposition sources and oxygen in the oxide film on the Si substrate were thermally reacted by the MBE method without using oxygen to form a single crystal film of a metal oxide as the buffer film 12 (see Fig. 1) on the Si substrate. Next, oxygen was introduced, the temperature was lowered, and the pressure was increased to form a single crystal film of the metal oxide as the buffer film 12 (see Fig. 1) by the MBE method. Note that the conditions of the MBE method during this film formation were as follows. Further, the value of Hf:Zr was a target value of 25:75 (x in the above composition formula (Chemical Formula 4) was 0.75). Note that in Example 6, Y and Al were added to HZO, and the value of Hf : Zr : Y : Al (atomic ratio, the same applies hereinafter) at this time was a target value of 23.75 : 71.25 : 2.5 : 2.5 (x, y, and z in the above composition formula (Chemical Formula 5) were 0.7125, 0.025, and 0.025, respectively).
Vapor deposition source: Hf, Zr, Y, Al
Voltage: 3.5 to 4.75 V
Pressure: 3 × 10⁻² to 6 × 10⁻² Pa
Substrate temperature: 450 to 700°C
Thickness: 25 nm

Next, a metal film of platinum (Pt) was formed as the metal film 13 on the single crystal film of the metal oxide as the buffer film 12 by the sputtering method. The conditions at this time are shown below.
Apparatus: Sputtering apparatus QAM-4 manufactured by ULVAC, Inc.
Pressure: 1.20 × 10⁻¹ Pa
Target: Pt
Power: 100 W (DC)
Thickness: 5 nm
Substrate temperature: 450 to 600°C

Next, the metal film 14 made of Ir was formed on the metal film 13 by the vapor deposition method. The conditions at this time are shown below.
Vapor deposition source: Ir
Pressure: 4 × 10⁻⁴ Pa
Substrate temperature: 550°C
Film thickness: 20 nm

In this way, the metal film 14 made of Ir was formed on the buffer film 12 via the metal film 13 by the vapor deposition method to produce the laminated structure of Example 6. Note that as described with reference to Fig. 3 described above, the metal film 13 does not have to be formed between the buffer film 12 and the metal film 14, and the metal film 14 may be formed on the buffer film 12 without interposing the metal film 13 therebetween. However, by forming the metal film 13 between the buffer film 12 and the metal film 14, the metal film 14 can be easily epitaxially grown on the buffer film 12.

### [X-Ray Diffraction Measurement]

After the buffer film 12 was formed on the principal surface 11p of the substrate 11 and before the metal film 13 was formed, the diffraction pattern of the laminated structure was measured by the X-ray diffraction measurement using the θ-2θ method in a state where the laminated structure was disposed such that a diffraction surface in the X-ray diffraction measurement was parallel to the principal surface 11p. As the measured diffraction pattern, results similar to those illustrated in Fig. 10 in Example 1 were obtained, and it has become clear that HZO contained in the metal oxide is (100) oriented in the pseudo-cubic representation.

Further, a φ scan was performed on a (220) plane (2θ = 50°) of HZO contained in the metal oxide. In the φ scan, results similar to those illustrated in Fig. 11 in Example 1 were obtained, and it has become clear that the crystal axes of HZO contained in the metal oxide are aligned also in the in-plane direction along the principal surface 11p of the substrate 11, that is, the HZO is epitaxially grown.

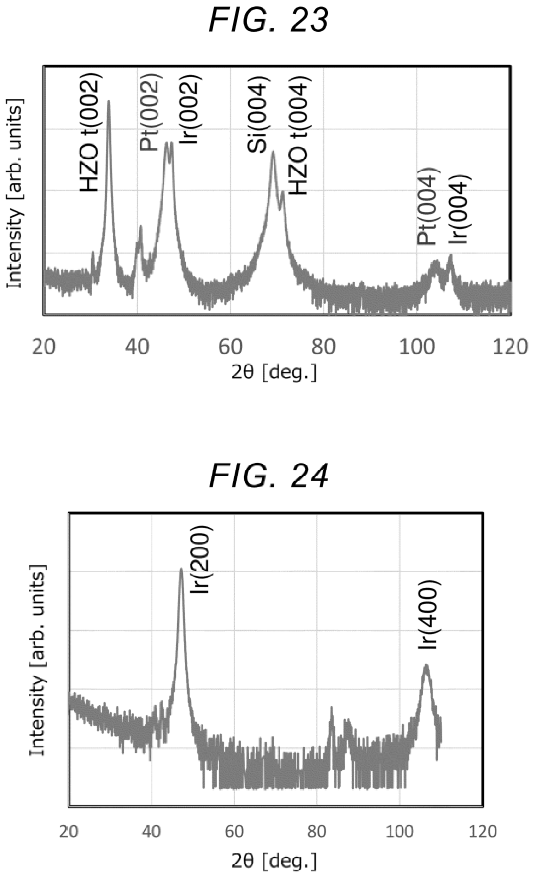

Further, after the metal film 13 and the metal film 14 were formed, the diffraction pattern of the obtained laminated structure of Example 6 was measured by the X-ray diffraction measurement using the θ-2θ method in a state where the laminated structure was disposed such that the diffraction surface of the laminated structure of Example 6 in the X-ray diffraction measurement was parallel to the principal surface 11p. Fig. 23 illustrates the measured diffraction pattern of the laminated structure of Example 6.

As illustrated in Fig. 23, in the measured diffraction pattern of Example 6, a strong diffraction peak of a tetragonal (002) plane of HZO (HZO t(002)) and a strong diffraction peak of a tetragonal (004) plane of HZO (HZO t(004)), a strong diffraction peak of a cubic (200) plane of Pt (Pt (002)) and a strong diffraction peak of a cubic (400) plane of Pt (Pt (004)), and a strong diffraction peak of a cubic (200) plane of Ir (Ir (002)) and a strong diffraction peak of a cubic (400) plane of Ir (Ir (004)) were observed. Therefore, in Example 6, it has become clear that HZO contained in the buffer film 12 is (100) oriented in the pseudo-cubic representation, Pt contained in the metal film 13 has a cubic crystal structure and is (100) oriented, and Ir contained in the metal film 14 has a cubic crystal structure and is (100) oriented.

Further, after the metal film 13 and the metal film 14 were formed, the diffraction pattern of the metal film 14, which is the uppermost layer of the obtained laminated structure of Example 6, was measured by the X-ray diffraction measurement using the θ-2θ method in a state (in-plane measurement) where the laminated structure was disposed such that the diffraction surface of the laminated structure of Example 6 in the X-ray diffraction measurement was inclined at 90° relative to the principal surface 11p. Fig. 24 illustrates the measured diffraction pattern of the laminated structure of Example 6.

As illustrated in Fig. 24, in the diffraction pattern (in-plane measurement) of Example 6, a strong diffraction peak of the cubic (200) plane of Ir (Ir (200)) and a strong diffraction peak of the cubic (400) plane of Ir (Ir (400)) were observed. Therefore, it has become clear that the crystal axes of Ir contained in the metal film 14 are aligned also in the in-plane direction along the principal surface 11p of the substrate 11, that is, the Ir is epitaxially grown.

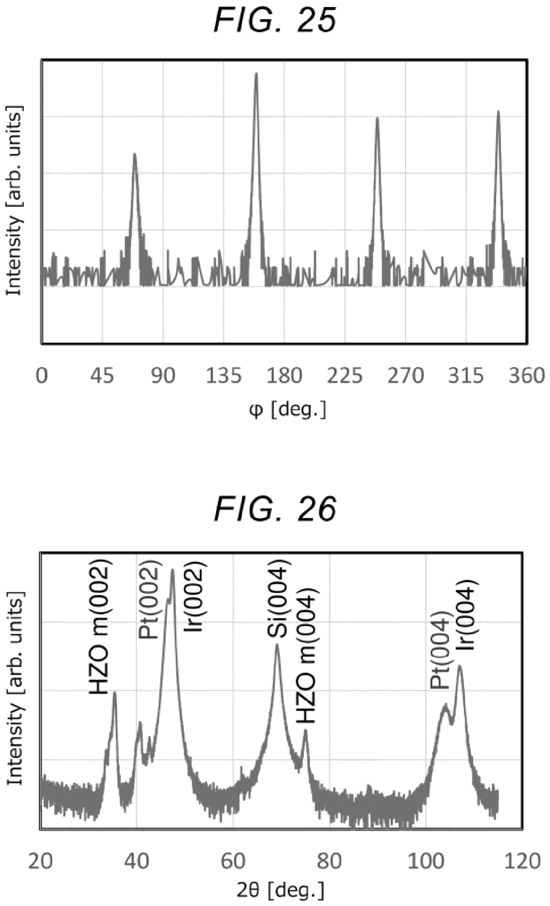

After the diffraction pattern (in-plane measurement) illustrated in Fig. 24 was measured, a φ scan was subsequently performed on the cubic (200) plane (2θ = 47°) of Ir contained in the metal film 14 in a state (in-plane measurement) where the laminated structure was disposed such that the diffraction surface in the X-ray diffraction measurement was inclined at 90° relative to the principal surface 11p. The φ scan measured for the metal film 14 of the laminated structure of Example 6 is illustrated in Fig. 25.

As illustrated in the graph of Fig. 25, in the φ scan, four strong diffraction peaks of the cubic (200) plane of Ir contained in the metal film 14 were observed every 90°. In other words, in the φ scan, diffraction peaks showing fourfold symmetry of Ir contained in the metal film 14 were observed. Therefore, as in Fig. 24, it has also become clear from Fig. 25 that the crystal axes of Ir contained in the metal film 14 are aligned also in the in-plane direction along the principal surface 11p of the substrate 11, that is, the Ir is epitaxially grown.

Note that although detailed description is omitted, also in a case where the metal film 13 made of Pt is not formed between the buffer film 12 and the metal film 14, a strong diffraction peak of the cubic (200) plane of Ir and a strong diffraction peak of the cubic (400) plane of Ir were observed in the diffraction pattern by the X-ray diffraction measurement using the θ-2θ method, and it has become clear that Ir contained in the metal film 14 has a cubic crystal structure and is (100) oriented. Further, in the φ scan of the cubic (200) plane of Ir, diffraction peaks showing fourfold symmetry were observed, and it has become clear that Ir contained in the metal film 14 is epitaxially grown. However, it has become clear that in a case where the metal film 13 is formed between the buffer film 12 and the metal film 14, as compared with a case where the metal film 13 is not formed between the buffer film 12 and the metal film 14, the metal film 14 can be easily epitaxially grown on the buffer film 12, for example, the intensity of the diffraction peaks showing fourfold symmetry increases in the φ scan of the cubic (200) plane of Ir.

Further, although detailed description is omitted, when the buffer film 12 is made of the metal oxide represented by the above composition formula (Chemical Formula 5), also in a case where x in the above composition formula (Chemical Formula 5) satisfies 0 ≤ x < 1, y in the above composition formula (Chemical Formula 5) satisfies 0 < y ≤ 0.3, and z in the above composition formula (Chemical Formula 5) satisfies 0 < z ≤ 0.3, results similar to those in Example 6 in which the ratio of Hf : Zr : Y : Al is 23.75 : 71.25 : 2.5 : 2.5 (x, y, and z in the above composition formula (Chemical Formula 5) are 0.7125, 0.025, and 0.025, respectively) were obtained.

Further, although detailed description is omitted, when the buffer film 12 does not contain Y or Al, that is, when the buffer film 12 is made of the first metal oxide represented by the above composition formula (Chemical Formula 4), also in a case where x in the above composition formula (Chemical Formula 4) satisfies 0 ≤ x < 1 or x satisfies x = 1, results similar to those in a case where the ratio of Hf : Zr is 25 : 75 (x in the above composition formula (Chemical Formula 4) is 0.75) were obtained. However, it has become clear that in a case where the buffer film 12 contains Y and Al, as compared with a case where the buffer film 12 does not contain Y or Al, the metal film 14 can be easily epitaxially grown on the buffer film 12, for example, the intensity of the diffraction peaks showing fourfold symmetry increases in the φ scan of the cubic (200) plane of Ir.

### (Example 7)

### [Formation of Laminated Structure]

Next, a laminated structure of Example 7 was produced in exactly the same manner as in Example 6 except that the metal film 14 made of Ir was formed on the buffer film 12 at 400°C instead of 550°C.

### [X-Ray Diffraction Measurement]

Also in the laminated structure of Example 7, similarly to the laminated structure of Example 6, it has become clear that HZO contained in the metal oxide contained in the buffer film 12 is (100) oriented in the pseudo-cubic representation, and is epitaxially grown.

Further, after the metal film 13 and the metal film 14 were formed, the diffraction pattern of the obtained laminated structure of Example 7 was measured by the X-ray diffraction measurement using the θ-2θ method in a state where the laminated structure was disposed such that a diffraction surface of the laminated structure of Example 7 in the X-ray diffraction measurement was parallel to the principal surface 11p. Fig. 26 illustrates the measured diffraction pattern of the laminated structure of Example 7.

As illustrated in Fig. 26, in the measured diffraction pattern of Example 7, a strong diffraction peak of a monoclinic (002) plane of HZO (HZO m(002)) and a strong diffraction peak of a monoclinic (004) plane of HZO (HZO m(004)), a strong diffraction peak of a cubic (200) plane of Pt (Pt (002)) and a strong diffraction peak of a cubic (400) plane of Pt (Pt (004)), and a strong diffraction peak of a cubic (200) plane of Ir (Ir (002)) and a strong diffraction peak of a cubic (400) plane of Ir (Ir (004)) were observed. Therefore, also in Example 7, as in Example 6, it has become clear that HZO contained in the buffer film 12 is (100) oriented in the pseudo-cubic representation, Pt contained in the metal film 13 has a cubic crystal structure and is (100) oriented, and Ir contained in the metal film 14 has a cubic crystal structure and is (100) oriented.

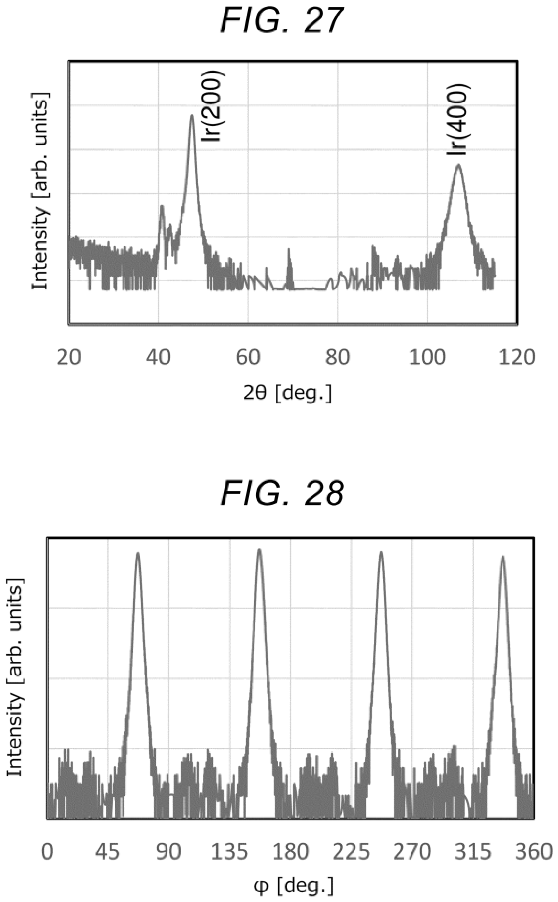

Further, after the metal film 13 and the metal film 14 were formed, the diffraction pattern of the metal film 14, which is the uppermost layer of the obtained laminated structure of Example 7, was measured by the X-ray diffraction measurement using the θ-2θ method in a state (in-plane measurement) where the laminated structure was disposed such that the diffraction surface of the laminated structure of Example 7 in the X-ray diffraction measurement was inclined at 90° relative to the principal surface 11p. Fig. 27 illustrates the measured diffraction pattern of the laminated structure of Example 7.

As illustrated in Fig. 27, in the diffraction pattern (in-plane measurement) of Example 7, a strong diffraction peak of the cubic (200) plane of Ir (Ir (200)) and a strong diffraction peak of the cubic (400) plane of Ir (Ir (400)) were observed. Therefore, it has become clear that the crystal axes of Ir contained in the metal film 14 are aligned also in the in-plane direction along the principal surface 11p of the substrate 11, that is, the Ir is epitaxially grown.

After the diffraction pattern (in-plane measurement) illustrated in Fig. 27 was measured, a φ scan was subsequently performed on the cubic (200) plane (2θ = 47°) of Ir contained in the metal film 14 in a state (in-plane measurement) where the laminated structure was disposed such that the diffraction surface in the X-ray diffraction measurement was inclined at 90° relative to the principal surface 11p. The φ scan measured for the metal film 14 of the laminated structure of Example 7 is illustrated in Fig. 28.

As illustrated in the graph of Fig. 28, in the φ scan, four strong diffraction peaks of the cubic (200) plane of Ir contained in the metal film 14 were observed every 90°. In other words, in the φ scan, diffraction peaks showing fourfold symmetry of Ir contained in the metal film 14 were observed. Therefore, as in Fig. 27, it has also become clear from Fig. 28 that the crystal axes of Ir contained in the metal film 14 are aligned also in the in-plane direction along the principal surface 11p of the substrate 11, that is, the Ir is epitaxially grown.

Note that although detailed description is omitted, also in a case where the metal film 13 made of Pt is not formed between the buffer film 12 and the metal film 14, a strong diffraction peak of the cubic (200) plane of Ir and a strong diffraction peak of the cubic (400) plane of Ir were observed in the diffraction pattern by the X-ray diffraction measurement using the θ-2θ method, and it has become clear that Ir contained in the metal film 14 has a cubic crystal structure and is (100) oriented. Further, in the φ scan of the cubic (200) plane of Ir, diffraction peaks showing fourfold symmetry were observed, and it has become clear that Ir contained in the metal film 14 is epitaxially grown. However, it has become clear that in a case where the metal film 13 is formed between the buffer film 12 and the metal film 14, as compared with a case where the metal film 13 is not formed between the buffer film 12 and the metal film 14, the metal film 14 can be easily epitaxially grown on the buffer film 12, for example, the intensity of the diffraction peaks showing fourfold symmetry increases in the φ scan of the cubic (200) plane of Ir.

Further, although detailed description is omitted, when the buffer film 12 is made of the metal oxide represented by the above composition formula (Chemical Formula 5), also in a case where x in the above composition formula (Chemical Formula 5) satisfies 0 ≤ x < 1, y in the above composition formula (Chemical Formula 5) satisfies 0 < y ≤ 0.3, and z in the above composition formula (Chemical Formula 5) satisfies 0 < z ≤ 0.3, results similar to those in Example 7 in which the ratio of Hf : Zr : Y : Al is 23.75 : 71.25 : 2.5 : 2.5 (x, y, and z in the above composition formula (Chemical Formula 5) are 0.7125, 0.025, and 0.025, respectively) were obtained.

Further, although detailed description is omitted, when the buffer film 12 does not contain Y or Al, that is, when the buffer film 12 is made of the first metal oxide represented by the above composition formula (Chemical Formula 4), also in a case where x in the above composition formula (Chemical Formula 4) satisfies 0 ≤ x < 1 or x satisfies x = 1, results similar to those in a case where the ratio of Hf : Zr is 25 : 75 (x in the above composition formula (Chemical Formula 4) is 0.75) were obtained. However, it has become clear that in a case where the buffer film 12 contains Y and Al, as compared with a case where the buffer film 12 does not contain Y or Al, the metal film 14 can be easily epitaxially grown on the buffer film 12, for example, the intensity of the diffraction peaks showing fourfold symmetry increases in the φ scan of the cubic (200) plane of Ir.

### (Example 8)

### [Formation of Laminated Structure]

Next, a laminated structure of Example 8 was produced in the same manner as in Example 6 except that a Si (111) substrate was used as the substrate 11 instead of a Si (100) substrate.

### [X-Ray Diffraction Measurement]

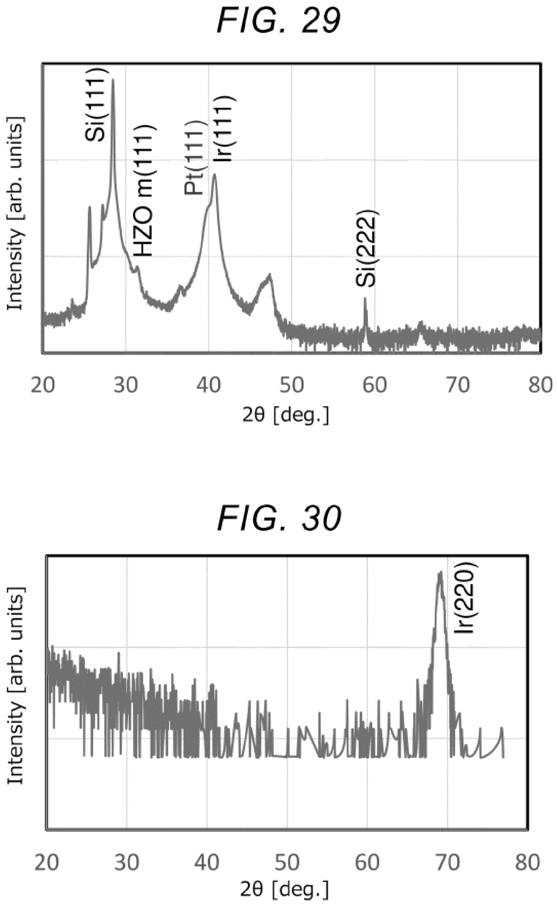

After the buffer film 12, the metal film 13, and the metal film 14 were formed on the principal surface 11p of the substrate 11, the diffraction pattern of the laminated structure was measured by the X-ray diffraction measurement using the θ-2θ method in a state where the laminated structure was disposed such that a diffraction surface in the X-ray diffraction measurement was parallel to the principal surface 11p. Fig. 29 illustrates the measured diffraction pattern of the laminated structure of Example 8.

As illustrated in Fig. 29, in the measured diffraction pattern of Example 8, a strong diffraction peak of a monoclinic (111) plane of HZO (HZO m(111)), a strong diffraction peak of a cubic (111) plane of Pt (Pt (111)), and a strong diffraction peak of a cubic (111) plane of Ir (Ir (111)) were observed. Therefore, in Example 8, it has become clear that HZO contained in the buffer film 12 is (111) oriented in the pseudo-cubic representation, Pt contained in the metal film 13 has a cubic crystal structure and is (111) oriented, and Ir contained in the metal film 14 has a cubic crystal structure and is (111) oriented.

Further, after the metal film 13 and the metal film 14 were formed, the diffraction pattern of the metal film 14, which is the uppermost layer of the obtained laminated structure of Example 8, was measured by the X-ray diffraction measurement using the θ-2θ method in a state (in-plane measurement) where the laminated structure was disposed such that the diffraction surface of the laminated structure of Example 8 in the X-ray diffraction measurement was inclined at 90° relative to the principal surface 11p. Fig. 30 illustrates the measured diffraction pattern of the laminated structure of Example 8.

As illustrated in Fig. 30, in the diffraction pattern (in-plane measurement) of Example 8, a strong diffraction peak of a cubic (220) plane of Ir (Ir (220)) was observed. Therefore, it has become clear that the crystal axes of Ir contained in the metal film 14 are aligned also in the in-plane direction along the principal surface 11p of the substrate 11, that is, the Ir is epitaxially grown.

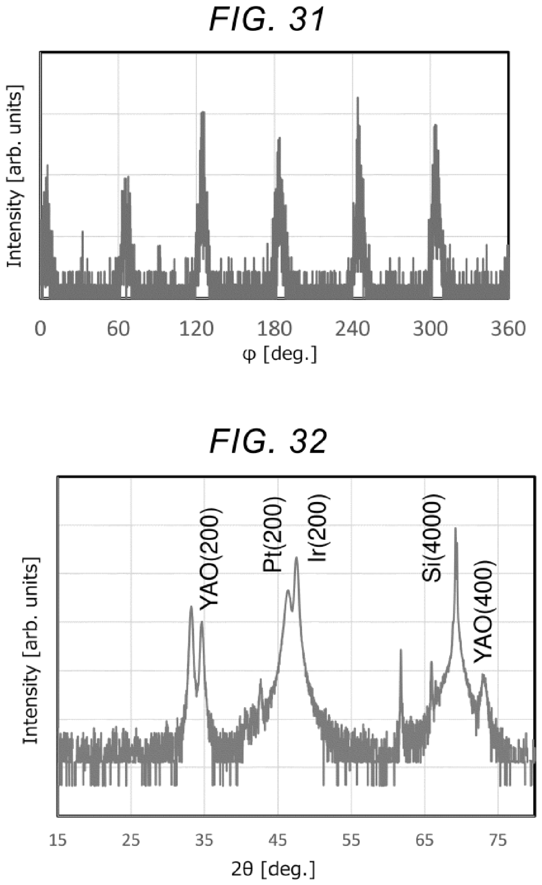

After the diffraction pattern (in-plane measurement) illustrated in Fig. 30 was measured, a φ scan was subsequently performed on the cubic (220) plane (2θ = 69°) of Ir contained in the metal film 14 in a state (in-plane measurement) where the laminated structure was disposed such that the diffraction surface in the X-ray diffraction measurement was inclined at 90° relative to the principal surface 11p. The φ scan measured for the metal film 14 of the laminated structure of Example 8 is illustrated in Fig. 31.

As illustrated in the graph of Fig. 31, in the φ scan, six strong diffraction peaks of the cubic (220) plane of Ir contained in the metal film 14 were observed every 60°. In other words, in the φ scan, diffraction peaks showing sixfold symmetry of Ir contained in the metal film 14 were observed. This means that the metal film 14, which is made of Ir, has a cubic crystal structure and is (111) oriented, and is composed of two domains each having threefold symmetry in plan view, one being rotated by 60° relative to the other. Therefore, as in Fig. 30, it has also become clear from Fig. 31 that the crystal axes of Ir contained in the metal film 14 are aligned also in the in-plane direction along the principal surface 11p of the substrate 11, that is, the Ir is epitaxially grown.

Note that although detailed description is omitted, also in a case where the metal film 13 made of Pt is not formed between the buffer film 12 and the metal film 14, a strong diffraction peak of the cubic (111) plane of Ir was observed in the diffraction pattern by the X-ray diffraction measurement using the θ-2θ method, and it has become clear that Ir contained in the metal film 14 has a cubic crystal structure and is (111) oriented. Further, in the φ scan of the cubic (220) plane of Ir, diffraction peaks showing sixfold symmetry were observed, and it has become clear that Ir contained in the metal film 14 is epitaxially grown. However, it has become clear that in a case where the metal film 13 is formed between the buffer film 12 and the metal film 14, as compared with a case where the metal film 13 is not formed between the buffer film 12 and the metal film 14, the metal film 14 can be easily epitaxially grown on the buffer film 12, for example, the intensity of the diffraction peaks showing sixfold symmetry increases in the φ scan of the cubic (220) plane of Ir.

Further, although detailed description is omitted, when the buffer film 12 is made of the metal oxide represented by the above composition formula (Chemical Formula 5), also in a case where x in the above composition formula (Chemical Formula 5) satisfies 0 ≤ x < 1, y in the above composition formula (Chemical Formula 5) satisfies 0 < y ≤ 0.3, and z in the above composition formula (Chemical Formula 5) satisfies 0 < z ≤ 0.3, results similar to those in Example 8 in which the ratio of Hf : Zr : Y : Al is 23.75 : 71.25 : 2.5 : 2.5 (x, y, and z in the above composition formula (Chemical Formula 5) are 0.7125, 0.025, and 0.025, respectively) were obtained.

Further, although detailed description is omitted, when the buffer film 12 does not contain Y or Al, that is, when the buffer film 12 is made of the first metal oxide represented by the above composition formula (Chemical Formula 4), also in a case where x in the above composition formula (Chemical Formula 4) satisfies 0 ≤ x < 1 or x satisfies x = 1, results similar to those in a case where the ratio of Hf : Zr is 25 : 75 (x in the above composition formula (Chemical Formula 4) is 0.75) were obtained. However, it has become clear that in a case where the buffer film 12 contains Y and Al, as compared with a case where the buffer film 12 does not contain Y or Al, the metal film 14 can be easily epitaxially grown on the buffer film 12, for example, the intensity of the diffraction peaks showing sixfold symmetry increases in the φ scan of the cubic (220) plane of Ir.

### (Example 9)

### [Formation of Laminated Structure]

Next, a laminated structure of Example 9 was produced in exactly the same manner as in Example 6 except that the buffer film 12 including the buffer film 12a (see Fig. 6) that is made of the second metal oxide containing YSZ, the buffer film 12b (see Fig. 6) that is formed on the buffer film 12a and is made of YAlO₃, which is the third metal oxide containing Y and Al, and the buffer film 12c (see Fig. 6) that is formed on the buffer film 12b and is made of CeO₂, which is the fourth metal oxide containing Ce, was formed instead of the buffer film 12 made of a metal oxide containing Hf, Zr, Y, and Al. Note that the film thickness of the buffer film 12a was 5 nm, the film thickness of the buffer film 12b was 20 nm, the film thickness of the buffer film 12c was 2.5 nm, the film thickness of the metal film 13 was 5 nm, and the film thickness of the metal film 14 was 20 nm.

### [X-Ray Diffraction Measurement]

After the buffer film 12, the metal film 13, and the metal film 14 were formed on the principal surface 11p of the substrate 11, the diffraction pattern of the laminated structure was measured by the X-ray diffraction measurement using the θ-2θ method in a state where the laminated structure was disposed such that a diffraction surface in the X-ray diffraction measurement was parallel to the principal surface 11p. Fig. 32 illustrates the measured diffraction pattern of the laminated structure of Example 9.

As illustrated in Fig. 32, in the measured diffraction pattern of Example 9, a strong diffraction peak of a (200) plane in the pseudo-cubic representation of YAlO₃ (YAO (200)), a strong diffraction peak of a (400) plane in the pseudo-cubic representation of YAlO₃ (YAO (400)), a strong diffraction peak of a cubic (200) plane of Pt (Pt (200)), and a strong diffraction peak of a cubic (200) plane of Ir (Ir (200)) were observed. Therefore, in Example 9, it has become clear that YAlO₃ contained in the buffer film 12b is (100) oriented in the pseudo-cubic representation, Pt contained in the metal film 13 has a cubic crystal structure and is (100) oriented, and Ir contained in the metal film 14 has a cubic crystal structure and is (100) oriented.

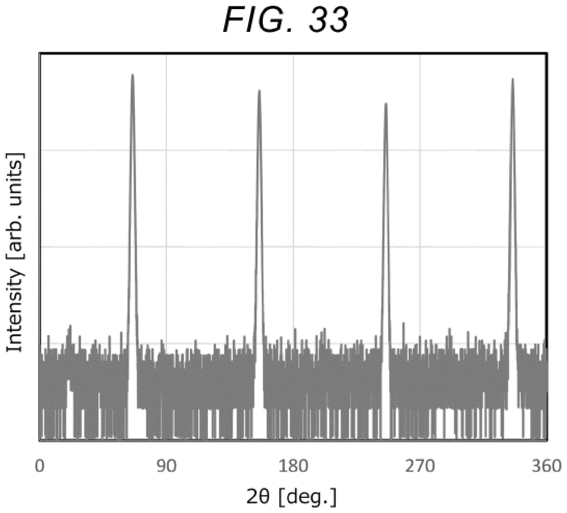

Further, after the metal film 13 and the metal film 14 were formed, a φ scan was performed on the cubic (220) plane (2θ = 69°) of Ir contained in the metal film 14, in a state (in-plane measurement) where the laminated structure was disposed such that the diffraction surface in the X-ray diffraction measurement was inclined at 90° relative to the principal surface 11p. The φ scan measured for the metal film 14 of the laminated structure of Example 9 is illustrated in Fig. 33.

As illustrated in the graph of Fig. 33, in the φ scan, four strong diffraction peaks of the cubic (220) plane of Ir contained in the metal film 14 were observed every 90°. In other words, in the φ scan, diffraction peaks showing fourfold symmetry of Ir contained in the metal film 14 were observed. Therefore, it has become clear that the crystal axes of Ir contained in the metal film 14 are aligned also in the in-plane direction along the principal surface 11p of the substrate 11, that is, the Ir is epitaxially grown.

Note that although detailed description is omitted, also in a case where the buffer film 12c made of CeO₂ or the metal film 13 made of Pt is not formed between the buffer film 12b made of YAlO₃ and the metal film 14 made of Ir, a strong diffraction peak of the cubic (200) plane of Ir was observed in the diffraction pattern by the X-ray diffraction measurement using the θ-2θ method, and it has become clear that Ir contained in the metal film 14 has a cubic crystal structure and is (100) oriented. However, it has been found that in a case where the buffer film 12c and the metal film 13 are formed between the buffer film 12b and the metal film 14, the growth rate of the metal film 14 can be greatly improved as compared with the growth rate of the metal film 14 in a case where the buffer film 12c or the metal film 13 is not formed between the buffer film 12b and the metal film 14.

Further, although detailed description is omitted, also in a case where the buffer film 12a made of the second metal oxide containing YSH instead of YSZ was used as the buffer film 12a, results similar to those in Example 9 in which the buffer film 12a made of the second metal oxide containing YSZ was used as the buffer film 12a were obtained.

### Reference Signs List

- 10, 10a: laminated structure
- 11: substrate
- 11a: base body
- 11b: insulating layer
- 11c: SOI layer
- 11p: principal surface
- 12, 12a to 12d: buffer film
- 13, 13a, 14, 14a, 22: metal film
- 20: electronic device
- 21: piezoelectric film
- 23: chamber
- 24: flow path
- 25: insulator film
- 26: conductive path
- 27: passivation film
- 28: conductive pad

## Claims

1. A laminated structure comprising:
a substrate including a principal surface;
a first buffer film formed on the principal surface; and
a first metal film formed on the first buffer film, wherein
the substrate is a Si substrate or an SOI substrate including a base body formed of a Si substrate, an insulating layer on the base body, and an SOI layer on the insulating layer,
the first buffer film is made of a first metal oxide represented by the following composition formula (Chemical Formula 1):
(Hf₁₋ₓZrₓ)O₂... (Chemical Formula 1)
the x satisfies 0 ≤ x < 1 or x = 1, and
the first metal film contains Fe, Cu, Mo, W, Ag, Al, Ti, or Ir as a main component.

2. The laminated structure according to claim 1, comprising
a second metal film formed on the first buffer film, wherein
the first metal film is formed on the second metal film, and
the second metal film is made of Pt.

3. The laminated structure according to claim 2, wherein
the first buffer film is made of the first metal oxide epitaxially grown on the principal surface,
the second metal film is made of Pt epitaxially grown on the first buffer film, and
the first metal film is epitaxially grown on the second metal film.

4. The laminated structure according to claim 2, wherein
the substrate is a Si (100) substrate including the principal surface formed of a Si (100) plane, or the SOI substrate including the base body formed of a Si substrate, the insulating layer on the base body, and the SOI layer on the insulating layer, the SOI layer being formed of a Si (100) film and including the principal surface formed of a Si (100) plane,
the first buffer film is made of the first metal oxide that is (100) oriented in a pseudo-cubic representation, and
the second metal film has a cubic crystal structure and is (100) oriented.

5. The laminated structure according to claim 4, wherein the first metal film contains Fe, has a cubic crystal structure, and is (100) oriented.

6. The laminated structure according to claim 5, wherein the first metal film contains Cr or Ni.

7. The laminated structure according to claim 4, wherein the first metal film contains Cu, has a cubic crystal structure, and is (100) oriented.

8. The laminated structure according to claim 4, wherein the first metal film contains Mo, has a cubic crystal structure, and is (110) oriented.

9. The laminated structure according to claim 4, wherein the first metal film contains W, has a cubic crystal structure, and is (110) oriented.

10. The laminated structure according to claim 4, wherein the first metal film contains Ag, has a cubic crystal structure, and is (100) oriented.

11. The laminated structure according to claim 4, wherein the first metal film contains Al, has a cubic crystal structure, and is (100) oriented.

12. The laminated structure according to claim 4, wherein the first metal film contains Ti, has a cubic crystal structure, and is (110) oriented.

13. The laminated structure according to claim 4, wherein the first metal film contains Ir, has a cubic crystal structure, and is (100) oriented.

14. The laminated structure according to claim 2, wherein
the substrate is a Si (111) substrate including the principal surface formed of a Si (111) plane, or the SOI substrate including the base body formed of a Si substrate, the insulating layer on the base body, and the SOI layer on the insulating layer, the SOI layer being formed of a Si (111) film and including the principal surface formed of a Si (111) plane,
the first buffer film is made of the first metal oxide that is (111) oriented in a pseudo-cubic representation, and
the second metal film has a cubic crystal structure and is (111) oriented.

15. The laminated structure according to claim 14, wherein the first metal film contains Ir, has a cubic crystal structure, and is (111) oriented.

16. The laminated structure according to claim 13 or 15, wherein
the first buffer film includes:
a second buffer film formed on the principal surface;
a third buffer film formed on the second buffer film; and
a fourth buffer film formed on the third buffer film,
the second buffer film is made of a second metal oxide represented by the following composition formula (Chemical Formula 2):
(Hf_{1-x1-y1}Zrₓ₁M_{y1})O_{2-z1}... (Chemical Formula 2)
(provided that in the composition formula (Chemical Formula 2), M is one or more selected from the group consisting of Nb, Ta, Si, Ti, a rare earth element, Al, and a Group 2 element),
the y1 satisfies 0 < y1 ≤ 0.3,
the x1 satisfies 0 ≤ x1 ≤ 1 - y1,
the third buffer film is made of a third metal oxide represented by the following composition formula (Chemical Formula 3):
(REₓ₂Al_{y2})O_{z2}... (Chemical Formula 3)
(provided that in the composition formula (Chemical Formula 3), RE is one or more selected from the group consisting of rare earth elements), and
the fourth buffer film is made of a fourth metal oxide containing Ce.

17. An electronic device comprising the laminated structure according to any one of claims 1 to 3.
